(19) Europäisches Patentamt

European Patent Office

Office européen des brevets

(11) **EP 1 727 283 A1**

(12) **DEMANDE DE BREVET EUROPEEN**

(43) Date de publication:
**29.11.2006 Bulletin 2006/48**

(51) Int Cl.:
*H03H 17/06* (2006.01)

(21) Numéro de dépôt: **06300498.0**

(22) Date de dépôt: **19.05.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **23.05.2005 FR 0505164**

(71) Demandeur: **Anagram Technologies SA**
**1028 Preverenges (CH)**

(72) Inventeur: **HEEB, Thierry**
**1044, FEY (CH)**

(74) Mandataire: **Grynwald, Albert**
**Cabinet GRYNWALD**
**16, Rue de la Paix**
**75002 Paris (FR)**

(54) **Procédé et dispositif de conversion de fréquence d'échatillonnage**

(57) L'invention concerne un procédé de conversion de fréquence d'échantillonnage de rapport prédéterminé entre une fréquence d'entrée ($Fsin$) et de sortie ($Fsout$). Il comprend une phase d'initialisation (40-44) de configuration sélective, en fonction du rapport de conversion, d'un filtre de sous-échantillonnage et d'un filtre passe-bande, et une phase en temps réel comprenant les étapes de sous-échantillonnage sélectif (45), de sur-échantillonnage par un facteur deux et de filtrage passe-bande sélectif (46), de sur-échantillonnage par un facteur soixante-quatre (47) et d'interpolation polynomiale de type "B-Spline" quadratique (48).

L'invention concerne aussi un dispositif (4) pour la mise en oeuvre du procédé.

## Fig. 16

## Description

L'invention concerne un procédé de conversion de fréquence d'échantillonnage d'un signal numérique.

L'invention concerne également un dispositif pour la mise en oeuvre du procédé.

Elle trouve une application particulière, bien que non exhaustive, dans le domaine du traitement numérique des signaux audio.

Pour fixer les idées, on se placera dans ce qui suit dans ce cas d'application préférée de l'invention.

De façon générale, beaucoup de processus modernes de traitement de signaux sont accomplis dans le domaine numérique. Diverses fréquences d'échantillonnage sont utilisées selon la qualité de signal exigée et la largeur de bande disponible du canal de transmission de données. Par exemple, les systèmes de traitement audio mettent typiquement en oeuvre des fréquences d'échantillonnage de 48, 96 ou 192 kHz pour une qualité audio professionnelle et une fréquence d'échantillonnage de 44,1 kHz pour une qualité dite "grand public", en ce qui concerne la qualité audio CD, et des fréquences d'échantillonnage de 8 kilohertz à 192 kHz pour les normes audio de compression/décompression traitant des signaux audio.

Pour simplifier la description, le Convertisseur de Fréquence d'Echantillonnage effectuant ce processus sera dénommé ci-après "SRC" (pour "Sampling rate Converter", selon la terminologie anglo-saxonne couramment utilisée).

L'utilisation d'un "SRC" effectuant une conversion de fréquence d'échantillonnage est inévitable dans des dispositifs d'interface disposés entre deux systèmes fonctionnant avec des fréquences d'échantillonnage différentes.

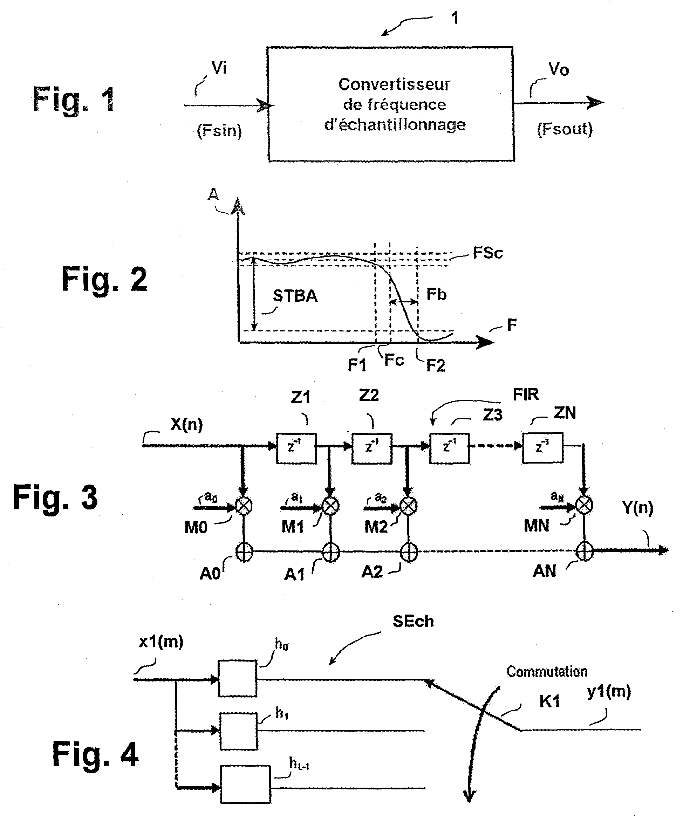

La figure 1 annexée à la présente description illustre très schématiquement un tel "SRC", référencé 1. Le signal d'entrée Vi est échantillonné à la fréquence *Fsin* et le signal de sortie Vo est échantillonné à la fréquence *Fsout.*

Dans la description qui suit, la dénomination Fs se rapporte à une fréquence d'échantillonnage générique tandis que *Fsin* et *Fsout* se rapportent explicitement aux fréquences d'entrée et de sortie respectivement.

Fondamentalement, la tâche d'un convertisseur asynchrone de fréquence d'échantillonnage, ou "SRC", est de calculer des données de sortie, échantillonnées, à une fréquence d'échantillonnage de sortie *Fsout,* en fonction de données d'entrée, à une fréquence d'échantillonnage d'entrée, et d'un rapport de conversion entre *Fsin* et *Fsout,* tous ces paramètres étant prédéterminés. En d'autres termes, la conversion de fréquence d'échantillonnage est réalisée en interpolant les données d'entrée pour générer des données de sortie à la fréquence d'échantillonnage de sortie. Le "SRC" est du type asynchrone si le rapport entre *Fsin* et *Fsout* ne peut pas être décrit comme un rapport de deux nombres entiers positifs. Dans la suite de la présente description, le terme "SRC" sera utilisé pour spécifier qu'il s'agit d'un convertisseur de fréquence d'échantillonnage du type asynchrone.

Les "SRC" sont souvent caractérisés par leur performances en termes dits de "THD+N" (selon l'abréviation anglo-saxonne couramment utilisée, pour "Total Harmonic Distorsion + Noise" ou "Distorsion Harmonique Totale + Bruit") et de "SNR" (selon l'abréviation anglo-saxonne couramment utilisé pour "Signal to Noise ratio" ou "rapport Signal sur Bruit"), et des rapports maximum et minimum possibles entre *Fsout* et *Fsin.* Les limitations associées à ces paramètres sont liées à l'algorithme utilisé pour obtenir la conversion de fréquence d'échantillonnage.

De nombreuses solutions ont été proposées dans l'Art Connu. A titre d'exemples non exhaustifs, on peut citer les "SRC" du marché typiques suivants :

- les circuits intégrés implémentant un "SRC", modèles SRC4190, SRC4192 et SRC4193, vendus par TEXAS INSTRUMENTS, Inc. (marque déposée), basés sur la technologie décrite dans le brevet US 6 747 858 B1 (Terry L. Sculley et al.) ;
- les circuits intégrés implémentant un "SRC", modèles AD1896 et AD1895, vendus par ANALOG DEVICES, Inc. (marque déposée), basés sur la technologie décrite dans le brevet US 6 141 671 B1 (Robert W. Adams et al) ; ou
- les circuits intégrés implémentant un "SRC", modèles CS8420 et CS8421, vendus par CIRRUS LOGIC, Inc.(marque déposée), basés sur la technologie décrite dans le brevet US 6 208 671 B1 (John Paulos et al.).

Le brevet Terry L. Sculley et al. (TEXAS INSTRUMENTS) est basé sur une boucle de rétroaction pour compenser des erreurs inhérentes au processus de conversion de fréquence d'échantillonnage. Cette caractéristique est semblable à celle mise en oeuvre dans un modulateur de type dit "delta-sigma". Un étage de filtre à décimation est utilisé en sortie d'un étage d'interpolation. Cette approche implique un fonctionnement à une vitesse plus importante que la fréquence d'échantillonnage de sortie. En outre, il est nécessaire de prévoir une mémoire de stockage, de type "ROM" (pour "Read Only Memory" ou "Mémoire à Lecture Seule") ou similaire de capacité relativement importante, le nombre de coefficients des filtres utilisés étant typiquement compris entre 500 et 1000.

Selon le brevet Robert W. Adams et al. (ANALOG DEVICES), le processus de conversion de fréquence d'échantillonnage est réalisé, de manière adaptative, en interpolant linéairement des coefficients de filtre pour obtenir la conversion de fréquence d'échantillonnage désirée. C'est le filtre entier (par exemple avec beaucoup de prises, typiquement 64 ou plus) qui est interpolé avant d'être appliquée au signal. De Nouveau, cette approche nécessite une quantité importante de mémoire "ROM" car, dans un mode de réalisation préféré, également celui mis en oeuvre dans les circuits intégrés précités, le nombre de coefficients du filtre qui en résulte est égal à 2048.

Le brevet John Paulos et al. (CIRRUS LOGIC) enseigne un processus de conversion de fréquence d'échantillonnage basé sur un sur-échantillonnage qui dépend du rapport entre $F_{sin}$ et $F_{sout}$, rapport *a priori* variable. Il se fonde sur les propriétés spectrales des images de fantômes qui apparaissent aux fréquences liées au sur-échantillonnage, par exemple en relation avec le rapport entre $F_{sin}$ et $F_{sout}$. De Nouveau, cette approche nécessite une quantité importante de mémoire "ROM" car le nombre de coefficients du filtre est typiquement égal à 8000.

En ce qui concerne les rapports de conversion possibles entre $F_{sin}$ et $F_{sout}$, on observe que l'approche TEXAS INSTRUMENT les limite typiquement à 16:1 ou 1:16, et les approches respectives ANALOG DEVICES et CIRRUS LOGIC toutes deux à 7,75:1 et 1:8, selon que $F_{sin}$ est plus grande ou plus petite que $F_{sout}$.

On constate donc que, entre autres, aucune des solutions rappelées de l'Art connu ne convient, par exemple, pour convertir une flot de données à la fréquence 8 kHz, générée par un téléphone mobile au standard "GSM", en un signal audio échantillonné à la fréquence 192 kHz.

Le besoin se fait donc sentir de disposer d'un procédé de conversion de fréquence d'échantillonnage ne présentant pas les inconvénients de l'Art Connu, dont certains viennent d'être rappelés brièvement.

C'est le but principal que se fixe l'invention.

En outre, elle se fixe pour but un procédé répondant à des besoins supplémentaires que ne couvre pas l'Art Connu.

Le procédé conforme à l'invention permet des rapports de conversion de fréquences d'échantillonnage, $F_{sin}/F_{sout}$, d'amplitude quasi illimitée. En effet, selon l'invention, la limitation de ce rapport est due aux seules limitations de puissance de calcul du dispositif de mise en oeuvre du procédé, et non plus aux limitations inhérentes à l'algorithme de base utilisé, comme c'est le cas dans l'Art Connu.

Un autre aspect important du procédé selon l'invention est sa capacité d'utiliser l'algorithme de conversion de fréquence d'échantillonnage, sur lequel il est fondé, pour calculer les coefficients variables de filtre. En effet, lorsque $F_{sout} < F_{sin}$, un filtre de limitation de bande passante doit être appliqué afin d'éviter un repliement de bande, ou "aliasing" selon la terminologie anglo-saxonne couramment utilisée. Il est clair que le filtrage de limitation de bande passante dépend du rapport de $F_{sin}/F_{sout}$. De ce fait, les coefficients de filtre varient avec ce rapport. Dans l'Art Connu, quelques coefficients de filtre sont modifiés (de façon continue et en temps réel) en utilisant un algorithme spécial d'adaptation de coefficients. Le procédé conforme à l'invention, comme indiqué ci-dessus et comme il le sera montré ci-après, utilise le même algorithme pour adapter le filtre de limitation de bande passante et pour exécuter la conversion de fréquence d'échantillonnage.

Un autre aspect important du procédé selon l'invention est qu'il permet de séparer la fonction "interpolation de données" de la fonction "limitation de bande passante" quand $F_{sout}$ est inférieur à $F_{sin}$. Dans les architectures "SRC" classiques de l'Art Connu, l'algorithme de conversion de fréquences d'échantillonnage mélange ces fonctions dans le chemin "temps réel" de l'algorithme. Selon le procédé de l'invention, les coefficients de filtre d'entrée sont adaptés afin d'obtenir une limitation de bande passante, mais cette adaptation n'est pas effectuée en temps réel, ni dans le chemin en temps réel de l'algorithme, ce qui exige des ressources informatiques, notamment une puissance de calcul, beaucoup plus réduites. Ainsi, selon le procédé de l'invention, la seule partie adaptative en temps réel est l'interpolation proprement dite. En outre, l'algorithme sous-jacent au procédé de l'invention, dans un mode de réalisation préféré, se présente comme un filtre à trois points seulement et qui met en oeuvre une technique basée sur les courbes mathématiques du type connu sous la dénomination "B-Splines", et plus précisément, dans un mode de réalisation préféré, de courbes "B-Splines" quadratiques.

Une autre caractéristique importante encore du procédé de conversion de fréquence d'échantillonnage selon l'invention est qu'il n'exige seulement que très peu de coefficients de filtre, ce qui ne requiert qu'une capacité de stockage réduite : mémoire de type "ROM" ou similaire. Typiquement, le nombre nécessaire de coefficients de filtre est au maximum égal à 600 dans un mode de réalisation préféré, mais il a été prouvé, dans un exemple de réalisation pratique, qu'un "SRC" mettant en oeuvre le procédé de l'invention pouvait être implémenté avec un nombre de coefficients de filtre beaucoup plus réduit, typiquement égal à 300, ce qui s'avère être très significativement en dessous du nombre de coefficients de filtre exigés par les procédés de l'art connu, notamment les procédé décrits dans les brevets américains précités.

Enfin, outre l'application principale visée par le procédé selon l'invention, à savoir la conversion de fréquences d'échantillonnage proprement dite, le procédé peut être mis en oeuvre avec profit dans de nombreuses applications, notamment à chaque fois que le besoin se fait sentir de synchroniser la fréquence d'échantillonnage des données avec celle des signaux générés par l'horloge générale d'un système.

A titre d'exemple non exhaustif, on peut citer les systèmes mettant en oeuvre des procédés connus sous l'abréviation anglo-saxonne "DSS", pour "Data to System synchronisation", dans lesquels on utilise classiquement des système de synchronisation de données numériques.

En résumé, le procédé de conversion de fréquences d'échantillonnage selon l'invention présente les avantages suivants :

- il présente une faible complexité et des performances élevées ;
- il met en oeuvre un polynôme d'interpolation des données d'ordre plus grand que 1 avec un filtre adaptatif court à trois points ;
- il permet des rapports de conversion entre les fréquences d'échantillonnage d'entrée et de sortie potentiellement illimités ;
- il permet la séparation entre les étapes de limitation de bande passante et d'interpolation ;
- il met en oeuvre le même algorithme pour exécuter la conversion de fréquence d'échantillonnage et dériver les coefficients de filtre limiteur de bande passante ; et
- il n'exige qu'une faible capacité de stockage, puisque le nombre de coefficients de filtre est peu élevé.

L'invention a donc pour objet principal un procédé de conversion de fréquence d'échantillonnage selon un rapport prédéterminé comprenant une première étape d'initialisation consistant à acquérir une première fréquence d'échantillonnage, dénommée *Fsin,* associée à un premier signal numérique, dit d'entrée, et à sélectionner une deuxième fréquence d'échantillonnage, dénommée *Fsout,* associée à un deuxième signal numérique, dit de sortie, le rapport entre lesdites première et deuxième fréquences d'échantillonnage constituant ledit rapport prédéterminé, caractérisé en ce qu'il comprend une phase d'initialisation comprenant :

- une première étape d'initialisation consistant à déterminer un nombre entier unique k, tel que la relation :

$$(Fsin/Fsout)/2^k > 1 \geq (Fsin/Fsout)/(2^{(k+1)})$$

soit satisfaite et a enregistrer ledit nombre dans des moyens de mémorisation ;
- une deuxième étape d'initialisation consistant, si $k > 0$, à configurer un filtre numérique de sous-échantillonnage dudit signal d'entrée par un facteur $2^k$, et a enregistrer les paramètres associés à cette configuration dans des moyens de mémorisation ;
- une troisième étape d'initialisation consistant à configurer un filtre numérique de limitation de bande passante de fréquence de coupure *Fsout*/2 et à déterminer ses coefficients si et seulement si l'une des relations suivantes est satisfaite : *Fsin>Fsout* $\geq$ *Fsin*/2 ou *Fsin*/2< *Fsout,* c'est-à-dire si $k \geq 0$, et à et a enregistrer lesdits coefficients dans des moyens de mémorisation ;

et une phase de processus réalisée en temps réel comprenant :

- une première étape de processus consistant, si et seulement si $k>0$, à appliquer ledit filtre numérique de sous-échantillonnage par un facteur $2^k$ au dit signal d'entrée, de façon à générer un premier signal intermédiaire ;
- une deuxième étape de processus consistant, si et seulement si $k \geq 0$, à appliquer ledit filtre numérique de limitation de bande passante au dit premier signal intermédiaire, et à court-circuiter ce filtre si $k<0$, de façon à générer un deuxième signal intermédiaire ;
- une troisième étape de processus consistant à sur-échantillonner ledit deuxième signal intermédiaire par un facteur prédéterminé *L* ; et
- une quatrième étape de processus consistant à appliquer au dit troisième signal intermédiaire un étage d'interpolation de données numériques de manière à générer ledit signal de sortie à la fréquence d'échantillonnage *Fsout.*

L'invention a encore pour objet un dispositif pour la mise en oeuvre du procédé.
L'invention va maintenant être décrite de façon plus détaillée en se référant aux dessins annexés, parmi lesquels :

- la figure 1 illustre schématiquement un exemple de réalisation d'un dispositif convertisseur de fréquence d'échantillonnage selon l'art connu ;
- la figure 2 illustre la courbe de réponse en fréquence d'un filtre passe-bas ;
- la figure 3 illustre schématiquement un filtre numérique de type dit *"FIR"*;
- la figure 4 illustre schématiquement un sur-échantillonneur de données numériques ;
- la figure 5 illustre schématiquement un circuit décimateur de données numériques ;
- la figure 6 illustre schématiquement un circuit décimateur de données numériques simplifié ;
- la figure 7 est une courbe illustrant schématiquement le processus d'interpolation, c'est-à-dire le fait de pouvoir calculer la valeur du signal en tout point de la courbe ;
- la figure 8 illustre, sous forme de blocs-diagrammes, les principales étapes du procédé de conversion de fréquence d'échantillonnage selon l'invention appliqué à un mode de sur-échantillonnage ;

- la figure 9 est une courbe illustrant schématiquement le spectre de fréquence obtenu dans ce mode de sur-échantillonnage ;
- les figures 10 à 12 sont des courbes illustrant schématiquement une étape d'interpolation faisant appel à des fonctions "B-Splines" quadratiques dans ce mode de sur-échantillonnage ;
- la figure 13 est une courbe illustrant schématiquement le spectre de fréquence obtenu dans un premier mode de sous-échantillonnage ;
- la figure 14 illustre, sous forme de blocs-diagrammes, les principales étapes du procédé de conversion de fréquence d'échantillonnage selon l'invention appliqué à un mode de sous-échantillonnage ;
- la figure 15 est une illustration schématique, sous forme de bloc diagramme, des étapes du procédé de conversion de fréquence d'échantillonnage selon l'invention, couvrant les modes de sous et sur-échantillonnage ; et
- la figure 16 illustre schématiquement un exemple d'architecture d'un dispositif implémentant le procédé de conversion de fréquence d'échantillonnage conforme à un mode de réalisation préféré de l'invention.

Dans ce qui suit, sans en limiter en quoi que ce soit la portée, on se placera ci-après dans le cadre de l'application préférée de l'invention, sauf mention contraire, c'est-à-dire dans le cas d'un dispositif convertisseur de fréquence d'échantillonnage ou "SRC" destiné au traitement de signaux audio.

Avant de décrire le procédé selon l'invention, et un dispositif pour la mise en oeuvre de ce procédé, il est utile de rappeler quelques caractéristiques fondamentales des composants et circuits constituant ce dispositif de mise en oeuvre.

En soi, les technologies mises en oeuvre sont bien connues et communes à l'Art Connu, ce qui d'ailleurs présente un avantage supplémentaire du procédé de l'invention, car il autorise le recours à des composants disponibles du commerce. Les caractéristiques innovantes de l'invention tiennent à leur agencement spécifique qui permet d'atteindre les buts qu'elle s'est fixée.

Dans les figures qui suivent, les éléments communs portent les mêmes références et ne seront re-décrits qu'en tant que de besoin.

Les filtres passe-bas constituent un premier composant mis en oeuvre dans le dispositif de l'invention.

Comme son nom l'indique, un filtre passe-bas laisse passer seulement des fréquences en dessous d'une fréquence prédéterminée et bloque les fréquences supérieures, pour le moins atténue fortement les fréquences au-dessus du point de coupure.

Plusieurs paramètres définissent un filtre passe-bas, comme illustré par la courbe de la figure 2 : l'axe vertical représente l'amplitude A du signal de sortie et l'axe horizontal son spectre de fréquences F.

*Fc* est la fréquence dite de coupure. Elle est normalement définie comme la fréquence pour laquelle le signal de sortie est atténué de 3 dB par rapport au signal d'entrée. Toutefois, les filtres utilisés dans les "SRC" sont du type dit "FIR" (pour "Finite-Impulse Response" ou "à "Réponse Impulsionnelle Finie") et cette définition est plutôt utilisée pour caractériser les filtres de type dit "IIR" (pour "Infiinite-Impulse Response" ou "à "Réponse Impulsionnelle infinie").

Idéalement, la réponse en fréquence dans la partie "bande passante" (partie inférieure du spectre comprise entre 0 et *Fc*) est plate. Cependant, pour beaucoup de types de filtres, il subsiste une ondulation résiduelle dans ce spectre : comprise entre des limites supérieure et inférieure (figurées par deux lignes en pointillés sur la figure 2), de part et d'autre d'une amplitude maximale idéale *FSc* (ligne en pointillé médiane). L'ondulation de "bande passante" est habituellement spécifiée comme étant l'amplitude maximale d'ondulation et est exprimé en dB.

On a également représenté sur la figure 2 d'autres paramètres caractéristiques importants : la fréquence maximale *F*1 de la bande passante (point d'inflexion de la courbe pour un filtre idéal), la fréquence inférieure de coupure de bande (amplitude du signal nulle pour un filtre parfait), le repliement arrière Fb (intervalle de fréquences entre *Fc* et *F*1) ou "Fold-Back" selon la terminologie anglo-saxonne, et atténuation de coupure de bande.

Dans le dispositif de l'invention, les filtres passe-bas sont avantageusement réalisés à base de filtres du type "FIR" précité, plus précisément des filtres à phases linéaires, ou, pour le moins, quasi linéaires.

La figure 3 illustre schématiquement un filtre de ce type, référencé *FIR.*

Le signal de sortie instantané $y(n)$ du filtre *FIR* à *N*+1 points de prise de signaux intermédiaires et *N* cellules, *Z*1 à *Z*N, constitués d'opérateurs de délai unitaire Z$^{-1}$, obéit à la relation ci-dessous :

$$y(n) = a_0 x(n) + a_1 x(n\text{-}1) + a_2 x(n\text{-}2) + \ldots a_N x(n\text{-}N) \qquad (1)$$

relation dans laquelle $x(n)$ est un échantillon d'entrée à l'instant n, de fréquence d'échantillonnage déterminée *Fs*.

Les blocs de bases de ce filtre *FIR* sont constitués des opérateurs de délais unitaires précités, *Z*1 à *Z*N, disposés en cascade (ligne supérieure), de *N*+1 additionneurs, *A*0 à *A*N, également disposés en cascade (ligne inférieure) et de

$N$+1 multiplieurs, $M0$ à $MN$. Ces derniers reçoivent, sur une première entrée, le signal x(n), pour $M0$, et les signaux en sortie des cellules, $Z1$ à $ZN$, pour $M1$ à $MN$, et sur une deuxième entrée, les paramètres $a_0$ à $a_N$ de la relation (1), constituant les coefficients du filtre $FIR$. Les signaux de sortie des multiplieurs $M0$ à $MN$, sont transmis à une deuxième entrée des additionneurs, $A0$ à $AN$, ces derniers recevant sur une première entrée (sauf le premier additionneur $A0$) le signal de sortie de l'additionneur qui le précède. Le signal de sortie du dernier additionneur est le signal de sortie du filtre et est égal à $y$(n) (relation (1)).

Un filtre de phase linéaire présente un retard identique à toutes les fréquences. Ceci assure une distorsion minimale des caractéristiques dans le domaine temps. En ce qui concerne les filtres "FIR" cette caractéristique peut être obtenue facilement choisissant pour les coefficients, $a_0$ à $a_N$, des nombres réels et symétriques.

Le sur-échantillonnage est l'opération qui consiste à augmenter la fréquence d'échantillonnage d'un signal donné par un facteur égal à un nombre entier, par exemple $L$. Ceci peut être réalisé en :

- insérant les ($L$-1) zéros entre les échantillons successifs d'entrée, ou "zero-padding" selon la terminologie anglo-saxonne couramment utilisée ; et
- en appliquant un filtre passe-bas au signal sur-échantillonné ainsi obtenu.

Le "zero-padding" peut être réalisé comme suit :

On suppose que $x(n)$ et $y(n)$ sont, respectivement, les signaux original et sur-échantillonné dans le "domaine temps" :

$$y(n) = \begin{cases} x\left(\dfrac{n}{L}\right) \\ 0 \quad autrement \end{cases} \quad \text{pour } n=0, \ \pm L, \ \pm 2L, \ \pm 3L, \pm 4L$$

ce qui a pour résultat transposé dans le "domaine fréquence" :

$$Y(f) = \sum_{n=-\infty}^{+\infty} u(n)e^{-j2\pi fn}$$

$$= \sum_{n=-\infty}^{+\infty} x(n)e^{-j2\pi fLn}$$

$$= X(Lf) \qquad\qquad (2)$$

Le remplissage de zéros crée un signal de fréquence d'échantillonnage supérieure dont le spectre est identique au spectre du signal original dans la largeur de bande originale, mais présentant des images fantômes, ou "alias", du spectre original centrées sur des multiples de la fréquence originale d'échantillonnage.

Dans ce contexte, le but d'un filtre passe-bas "FIR" est d'éliminer les signaux spectraux repliés provoqués par le remplissage de zéros.

Pour éviter des calculs inutiles, quand des échantillons d'entrée sont fixés à zéros, on utilise $L$ filtres polyphasés au lieu du remplissage de zéros pour accomplir le filtrage "FIR". Les filtres polyphasés sont des filtres secondaires dérivés du filtre linéaire original de phase "FIR".

La décomposition polyphasée d'un filtre "FIR", que l'on dénommera $H(z)$ de longueur $Ntotal$ (sur lequel on réalise un remplissage de zéros tel que la longueur soit un multiple de $L$) est donnée par la relation ci-dessous :

$$H(Z) = \sum_{i=0}^{L-1} Z^{-i} H_i\left(Z^L\right) \qquad (3)$$

relation dans laquelle les réponses impulsionnelles de $H_0(z)$, ..., $H_{L-1}(z)$ sont :

$$h_0(n) = \{h(0), h(L), h(2L) \ldots\}$$

$$h_1(n) = \{h(1), h(L+1), h(2L+1)\ldots\}$$

$$\ldots$$

$$h_{L-1}(n) = \{h(L-1), h(2L-1), h(3L-1) \ldots\}$$

Ainsi, pour chaque entrée, $L$ sorties sont calculées en effectuant $L$ calculs de "FIR" de base, chacun utilisant un ensemble différent de coefficients.

Le nombre de prises de chaque filtre polyphasé est égal à $Npolyphase = Ntotal/L$.

Les coefficients de chaque filtre polyphasé peuvent être déterminés en conservant seulement chaque $L$ ème coefficient, en commençant par les coefficients 0 jusqu'à $L$-1, de façon à calculer les sorties correspondantes 0 jusqu'à $L$-1.

La figure 4 illustre schématiquement un interpolateur, référencé $SEch$, effectuant ce processus. Le signal d'entrée, de fréquence d'échantillonnage $Fsin$, référencé $x1$ $(m)$, est transmis aux entrées de $L$ cellules, référencées $h_0$ à $h_{L-1}$. Un commutateur $K1$ balaye les sorties de ces cellules. Le signal de sortie $y1$ $(m)$ représente le résultat de la relation (3) ci-dessus, de fréquence d'échantillonnage $LxFsin$.

Le sous-échantillonnage est l'opération duale de l'opération précédemment rappelée. Elle consiste à diminuer la fréquence d'échantillonnage d'un signal donné par un facteur égal à un nombre entier. Naturellement, puisque la fréquence d'échantillonnage résultante est inférieure à celle d'entrée, un filtrage passe-bas doit être appliqué afin de supprimer les composantes non désirées de fréquence.

De façon pratique, diminuer la fréquence d'échantillonnage par un facteur $M$, nombre entier consiste à :

- appliquer au signal un filtre passe-bas ; et
- conserver uniquement les $M$ ème échantillons.

Le but d'un filtrage passe-bas, que l'on dénommera $Hm(f)$ est de limiter en bande passante le signal à une fréquence d'échantillonnage $Fsin/(2xM)$ pour se conformer aux exigences du théorème d'échantillonnage. En résultat, tout le contenu de signal au-dessus de la demi-fréquence d'échantillonnage $Fsout = Fsin/M$ est perdu. Ainsi, dans le domaine des fréquences, on obtient la relation suivante :

$$Hm(f) = \begin{cases} 1 \text{ pour } 0 < f < Fsin/2M \\ 0 \text{ pour } Fsin/2M < f < Fsin/2 \end{cases} \qquad (4)$$

Pour obtenir un signal décimé (c'est-à-dire un sous-échantillonnage), chaque $M$ème échantillon de sortie doit être conservé (la première phase, $\varphi_0$, est choisie arbitrairement), tous les autres échantillons sont sautés.

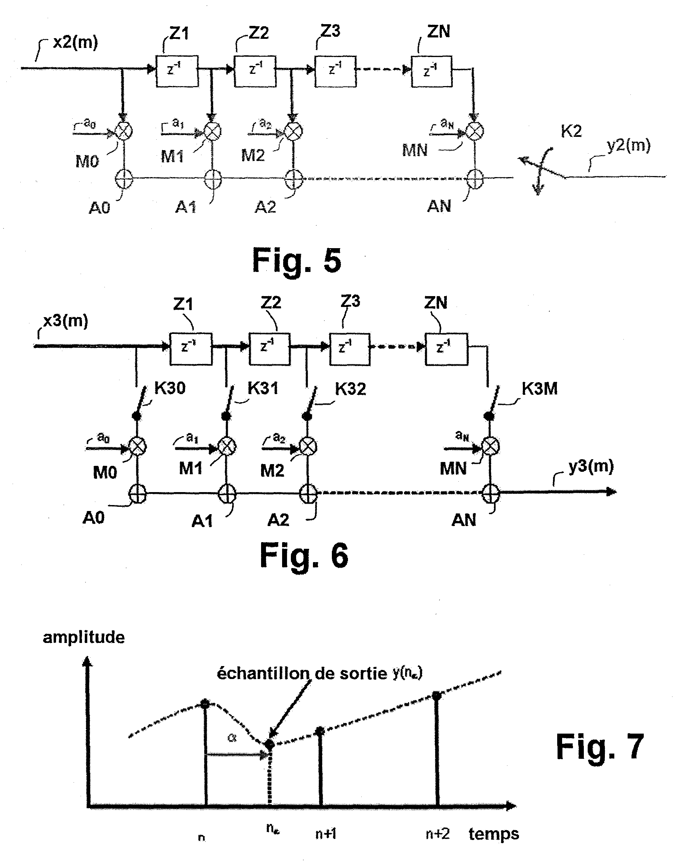

La figure 5 illustre schématiquement un décimateur, référencé $DEC$, réalisant l'opération rappelée ci-dessus. Les signaux d'entrée et de sortie sont référencés arbitrairement $x2(m)$ et $y2(m)$, respectivement. La configuration de du circuit $DEC$ est similaire à celle du circuit de la figure 3 : $N$ opérateurs de délais élémentaires $Z^{-1}$, $N+1$ multiplieurs, $M0$ à $MN$, recevant sur une de leurs deux entrées les coefficients du filtre, $a_0$ à $a_N$, comme précédemment, et $N+1$ additionneurs, $A0$ à $AN$. La différence principale consiste en l'interposition d'un commutateur, référencé $K2$, entre la sortie des circuits élémentaires précédemment décrits et la sortie du décimateur $DEC$ proprement dite, de manière à obtenir la décimation conforme à la relation (4). Ce commutateur K2 balaye en séquence $M$ étages identiques à celui représenté sur la figure 5.

Le signal de sortie $y2(m)$ représente le résultat de la relation (4) et sa fréquence d'échantillonnage $Fsout$ est égale à $Fsin/M$, $Fsin$ étant la fréquence d'échantillonnage du signal d'entrée $x2(m)$.

Il est toutefois possible réduire la quantité de calcul par un facteur $M$. La figure 6 illustre schématiquement un décimateur, référencé $DEC'$, permettant de réaliser une opération de décimation simplifiée.

Son architecture est très similaire à celle du décimateur de la figure 5. Les signaux d'entrée et de sortie, de fréquences d'échantillonnage $Fsin$ et $Fsout = Fsin/M$, sont référencés arbitrairement $x3(m)$ et $y3(m)$, respectivement.

La différence principale consiste dans le fait que le commutateur de sortie $K2$ de la figure 5, est remplacé par une série de $N+1$ commutateurs $K30$ à $K3N$, disposés entre l'entrée de signal $x3(m)$ et le multiplieur $M0$, d'une part, et les sorties des opérateurs $Z1$ à $ZN$, et les multiplieurs respectifs, $M1$ à $MN$, d'autre part.

L'interpolation de données est utilisée pour estimer la valeur d'une fonction entre des données connues sans connaître la fonction qui les représente effectivement. Les méthodes d'interpolation peuvent être réparties selon deux catégories principales.

- Interpolation globale :

  Ces méthodes se fondent sur la construction d'une équation simple qui adapte tous les points de données. Cette équation est habituellement une équation polynomiale de degré élevé.

- Interpolation par segments :

  Ces méthodes se fondent sur la construction de polynômes de degrés inférieurs entre deux points de données connus ou plus. Si un polynôme de premier degré est utilisé, il est appelé interpolation linéaire et l'interpolation correspond à une ligne droite entre deux points de données successifs. Pour les ordres polynomiaux d'ordre supérieur (ordre 2 et au-dessus), différents polynômes peuvent être utilisés.

Dans un mode de réalisation préféré de l'invention, des polynômes de type "B-Splines" sont utilisés. Pour les deuxième et troisième ordres de "B-Splines", ce procédé d'interpolation est dénommé quadratique et cubique respectivement. La courbe obtenue est d'autant plus lisse que le degré de "B-Splines" est élevé. Les "B-Splines" d'un degré $m$ ont des dérivées continues jusqu'au degré $m-1$ aux points de données.

L'interpolation à base de "B-Splines" est une technique utile pour obtenir une interpolation entre des points de données connus en considération de ses caractéristiques de stabilité et variations douces.

Dans un mode de réalisation préféré de l'invention, comme il a été rappelé, on recourt à un l'algorithme d'interpolation mettant en oeuvre des "B-Splines" quadratiques.

On suppose que $N_\alpha$ est un temps entre des temps $n$ et $n+1$ arbitraires et si $y(N_\alpha)$ représente l'échantillon de sortie interpolé au temps $N_\alpha$, on suppose en outre que $x(n)$, $x(n+1)$ et $x(n+2)$ représentent les échantillons d'entrée à $n$, $n+1$ et $n+2$, respectivement.

On peut démontrer que $y(N_\alpha)$ obéit à la relation suivante :

$$y(N_\alpha) = h_0 * x(n) + h_1 * x(n+1) + h_2 * x(n+2) \qquad (5)$$

avec

$$h_0 = (1/2) * (1 - \alpha)^2$$

$$h_1 = (1/2) * (1 + \alpha)^2 + (3/2) * \alpha^2$$

$$h_2 = (1/2) * \alpha^2$$

et :

- $y(N_\alpha)$ est l'échantillon de sortie au temps $N_\alpha$ ;
- $x(n)$, $x(n+1)$, $x(n+2)$ sont les échantillons d'entrée aux temps $n$, $n+1$, et n+2 respectivement ; et
- $\alpha$ est la différence de temps normalisée entre $N_\alpha$ et $n$ (c'est-à-dire ramenée à un nombre dans l'intervalle [0 ;1 [).

La figure 7 illustre schématiquement le processus d'interpolation de données qui vient d'être décrit. L'axe vertical représente l'amplitude du signal et l'axe horizontal le temps avec les instants *n, n+1, n+2* et $N_\alpha$ précités, ainsi que la valeur $\alpha$.

D'une manière générale la réponse en fréquence d'un "B-Spline" d'ordre $n$ ème appliqué à un signal échantillonné à la fréquence *Lfs* est donnée par la relation :

$$F(f)=\frac{\sin^{N+1}\left(\dfrac{\pi f}{Lfs}\right)}{\left(\dfrac{\pi f}{Lfs}\right)^{N+1}} \tag{6}$$

Il s'ensuit que la réponse en fréquence d'un système mettant en oeuvre une interpolation "B-Spline" quadratique à la fréquence critique $\phi=(L-1/2)fs$ est donnée par la relation :

$$E=\frac{\sin^3\left(\dfrac{\pi\left(L-\dfrac{1}{2}\right)f}{Lfs}\right)}{\left(\dfrac{\pi\left(L-\dfrac{1}{2}\right)f}{Lfs}\right)^3} \tag{7}$$

d'où

$$E\approx\frac{1}{(2L)^3} \tag{7bis}$$

relation dans laquelle $L$ est le facteur total de sur-échantillonnage.
Pour une longueur de mot binaire donnée $W$ et une étape de quantification $Q$, le facteur de sur-échantillonnage nécessaire L est calculé comme suit :

$$\frac{Q}{2}\geq\frac{1}{(2L)^3} \tag{8}$$

$$\frac{2^{-(w-1)}}{2}\geq\frac{1}{(2L)^3} \tag{8bis}$$

$$L\geq2^{\frac{w}{3}-1} \tag{8ter}$$

Ainsi, si des mots de 16 bits sont utilisés, le facteur minimum de sur-échantillonnage est $L = 2^{\frac{16}{3}-1} = 2^5 = 32.$ Les étapes de sur-échantillonnage effectuées avant l'interpolation de données conduisent typiquement à une fréquence d'échantillonnage d'au moins 32x*Fsin.*
Si des mots de 24 bits sont utilisés, le facteur minimum de sur-échantillonnage est

$$L = 2^{\frac{24}{3}-1} = 2^7 = 128.$$ Dans ce cas, les étapes de sur-échantillonnage effectuées avant l'interpolation de données conduisent typiquement à une fréquence d'échantillonnage d'au moins 128x*Fsin.*

A ce point, Il est intéressant de noter que, pour une précision de 16 bits, si on met en oeuvre une interpolation linéaire au lieu d'une interpolation "B-Spline" quadratique, cela exigerait un facteur de sur-échantillonnage égal à 128. Pour une précision de 24 bits, ce facteur de sur-échantillonnage s'élève à 2048, ce qui a pour résultat un nombre très élevé de coefficients de filtre à stocker, par exemple dans une mémoire "ROM".

D'après ce qui précède, on constate clairement que l'interpolation "B-Spline" quadratique autorise une interpolation de très haute précision même avec des fréquences d'échantillonnage modérées, ce qui constitue un des avantages du procédé selon l'invention. Un sur-échantillonnage de rapport 128 est tout à fait suffisant pour assurer une précision de 24 bits dans la bande de base [0 ; *Fs*/2].

Le procédé selon l'invention va maintenant être décrit de façon plus spécifique.

Le premier mode décrit va concerner le cas d'un sur-échantillonnage. Ce cas est particulièrement intéressant, car il sera montré ci-après que le cas du sous-échantillonnage est dérivé directement du mode de réalisation en sur-échantillonnage, car il met en oeuvre le même algorithme de base.

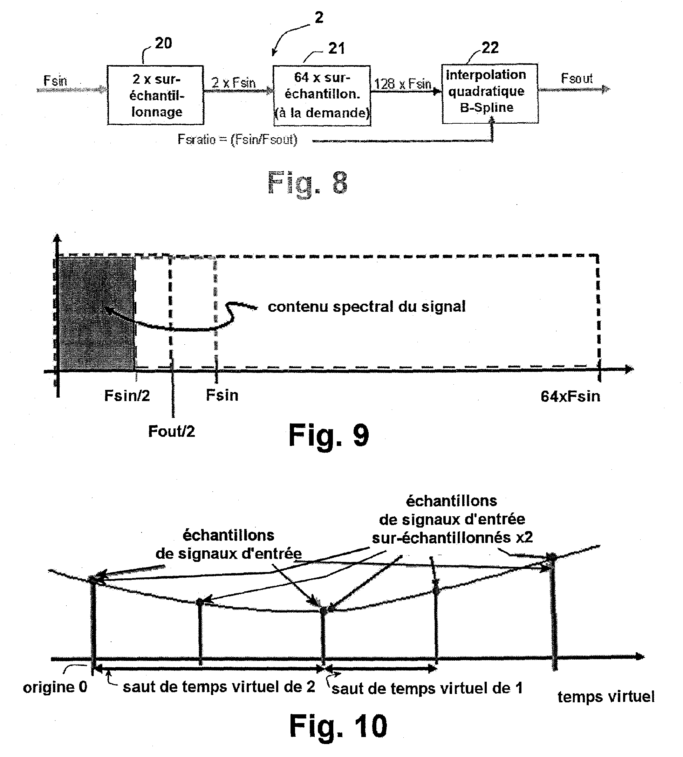

La figure 8 illustre, sous forme de blocs-diagrammes, sous la référence générale 2, les principales étapes du procédé selon l'invention appliqué à ce premier mode. Le circuit complet comporte trois blocs, 20 à 22.

Le signal d'entrée est échantillonné à la fréquence *Fsin* et le signal de sortie à la fréquence *Fsout.*

Dans le mode sur-échantillonnage, la fréquence d'échantillonnage de sortie *Fsout* est plus haute que la fréquence d'échantillonnage d'entrée *Fsin.* Aussi, le contenu complet du signal d'entrée dans le "domaine fréquence" est disponible dans le signal de sortie et aucun filtre limiteur de bande passante n'est nécessaire pour éviter le repliement de bande ("aliasing").

Dans un mode de réalisation préféré, les étapes du procédé sont les suivantes :

- Etape 1, dénommée "sur-échantillonnage 2x" (bloc 20) : le signal d'entrée est sur-échantillonné par un facteur 2. Ceci crée un signal interne (en sortie du bloc 20) échantillonné à 2x*Fsin* avec la partie supérieure du spectre "vide". Le signal d'entrée occupe seulement la largeur de bande 0 à *Fsin*/2).

- Etape 2, dénommée "sur-échantillonnage 64x" (bloc 21) : le signal en sortie du bloc 20, et reçu par le bloc 21, est encore sur-échantillonné par un facteur de 64, ce qui a pour résultat un signal interne (en sortie du bloc 21) sur-échantillonné à 128 x *Fsin* et avec un spectre vide dans la bande de fréquences allant de *Fsin*/2 à 64 x *Fsin* = 128xF*sin*/2).

- Etape 3 dénommée "interpolation "B-Spline" quadratique" (bloc 22) : une interpolation "B-Spline" quadratique est effectuée lors de cette étape finale pour générer un signal de sortie sur-échantillonné de fréquence *Fsout.* Comme *Fsout* est plus élevé que *Fsin,* il n'y a aucun risque d'apparition de composants de fréquence de repli de bande ("aliasing") dans la gamme de fréquence de sortie (soit 0 à *Fsout*/2). L'interpolation est effectuée sous la commande d'un signal représentant le rapport de fréquence d'échantillonnage *Fsratio = Fsin*/*Fsout,* qui sera détaillé ci-après. Ce paramètre de commande est transmis à une entrée du bloc 22 qui délivre en sortie le signal de sortie à la fréquence d'échantillonnage *Fsout.*

Le diagramme de la figure 9 illustre ce processus. L'axe vertical représente l'amplitude *A* du signal et l'axe horizontal est gradué en fréquence. On y a représenté les fréquences *Fsinl2, Fsoutl2, Fsin* et 64x *Fsin.* Dans la partie inférieure du spectre, entre 0 et *Fsinl2,* on a représenté en grisé le seul contenu du spectre de fréquences non vide.

Le premier étage (bloc 20) qui réalise le sur-échantillonnage 2x est basé sur un filtre de phase linéaire "FIR" du type précédemment décrit (voir par exemple figure 2). Il est utile de rappeler que, s'agissant d'un filtre de phase linéaire, ses coefficients sont symétriques. De ce fait, seule la moitié d'entre eux nécessite un stockage en mémoire.

Les caractéristiques de ce filtre sont rassemblées dans la "TABLE I" placée en fin de la présente description.

Le deuxième étage (bloc 21) qui réalise le sur-échantillonnage 64x est également basé sur un filtre de phase linéaire "FIR" du type précédemment décrit (voir par exemple figure 2). Il présente les mêmes avantages que rappelés ci-dessus. Combinée avec la première étape, cette étape porte le rapport de sur-échantillonnage à 128x.

Les caractéristiques de ce filtre sont rassemblées dans la "TABLE II" placée en fin de la présente description.

A ce stade de la description, deux remarques peuvent être formulées :

Le signal résultant des étapes 1 et 2 en cascade (sur-échantillonnages 2x et 64x) doit avoir pour caractéristique un spectre vide dans la gamme de fréquences *Fsin*/2 à 64x*Fsin.* Ceci est réalisé par le fait que le filtre de sur-échantillonnage 64x atténue toutes les répliques spectrales dues au processus de remplissage de zéros. En effet comme le signal d'entrée de ce filtre est un signal échantillonné à 2x*Fsin*, des répliques spectrales sont introduites autour des multiples de la fréquence 2x *Fsin* par le procédé de remplissage de zéros. En outre, le signal d'entrée du filtre 64x a un spectre vide de *Fsin*/2 à *Fsin.* Aussi, la première réplique spectrale (centrée sur 2x*Fsin*) se replie de 2x*Fsin* à *Fsin,* mais ne contient pas de contenu spectral significatif dans la bande de *Fsin* à 3xFsin/2. De ce fait, il est suffisant que le filtre de sur-échantillonnage 64x atténue fortement tous les composants de fréquence supérieure à 3x*Fsin*/2 au lieu de tous les composants au-dessus de *Fsin.* Ceci a comme conséquence avantageuse une atténuation considérable des conditions imposées à la bande de transition du filtre de sur-échantillonnage 64x et réduit le nombre de prises intermédiaires de signal du filtre. Typiquement, si le filtre de sur-échantillonnage 64x doit atténuer tous les composants de fréquence à partir de *Fsin,* vers les fréquences hautes, le nombre de prises était pratiquement doublé, ce qui avait pour conséquence des tables de plus grandes tailles, tables qui doivent être stockées en mémoire, par exemple dans une mémoire "ROM".

Comme il le sera précisé ci-après, la charge de calcul pour l'étape de sur-échantillonnage 64x peut être considérablement réduite en ne calculant seulement que les échantillons qui sont nécessaires. En effet, l'étape d'interpolation qui suit la deuxième étape met en oeuvre des "B-Splines" quadratiques qui exigent trois points de repères pour l'interpolation. De cette façon, tous les échantillons de sortie de l'étape de sur-échantillonnage64x ne sont pas exigés et certains peuvent être négligés, ce qui réduit corrélativement la quantité de calcul nécessaire.

L'étape 3, ou étape finale, du procédé selon l'invention, consiste, comme il a été indiqué, en une interpolation "B-Spline" quadratique qui permet une interpolation précise à partir seulement de trois points de données connus, à condition que ces points de données soient suffisamment proches du point d'interpolation. Il a été précédemment précisé qu'un rapport de sur-échantillonnage de 128, en ce qui concerne des données d'entrée, est suffisant pour obtenir une précision de 24 bits qui, en pratique, est la résolution la plus élevée actuellement utilisée en acoustique.

On va maintenant décrire de façon plus détaillée comment l'étape d'interpolation "B-Spline" est effectuée.

L'étape d'interpolation "B-Spline" est effectuée en utilisant un paramètre que l'on dénommera *Fsratio.* Ce paramètre est un rapport de fréquence d'échantillonnage avec *Fsratio = Fsin/Fsout.* Pour comprendre le processus de cette étape, on peut considérer une ligne abstraite de temps avec une origine de temps référencée arbitrairement 0 et considérer une base de temps virtuelle telle que l'intervalle (virtuel) de temps entre l'apparition de deux échantillons consécutifs des échantillons d'entrée sur-échantillonnés 2x est égal à l'unité.

La figure 10 illustre ce processus. L'axe horizontal est l'axe de temps virtuel précité, débutant arbitrairement à l'origine de temps virtuel 0. On a représenté trois échantillons de signaux d'entrée et cinq échantillons de signaux d'entrée sur-échantillonés 2x. On a également représenté deux intervalles de temps consécutifs : un saut de temps virtuel de 2 (c'est-à-dire entre deux échantillons d'entrée consécutifs) et un saut de temps virtuel de 1 (c'est-à-dire entre deux échantillons d'entrée consécutifs 2x). On a également représenté une courbe, dont la fonction qui la décrit n'est pas connue *a priori,* passant par ces échantillons.

Sur cette base de temps virtuelle, on peut exprimer les instants où un échantillon de sortie serait produit. En effet, connaissant le rapport existant entre *Fsin* et *Fsout,* et ayant placé une origine de temps virtuelle (origine 0), il devient possible de calculer le temps virtuel instantané pour lequel un échantillon de sortie est nécessaire.

Ceci est accompli comme suit : on suppose que les flux de données en entrée et sortie sont synchrones à l'origine des temps (par exemple un échantillon d'entrée est reçu au temps virtuel 0 et un échantillon de sortie est généré au temps virtuel 0). Il est toujours possible, puisqu'un délai abstrait pur est utilisé, de synchroniser les points de départ virtuels des flux de données. Dans la base virtuelle de temps décrite ci-dessus, le prochain échantillon de sortie est généré à l'instant $t1 = 2 \times Fsin/Fsout$. Puis, le prochain échantillon de sortie est généré à l'instant $t2 = t1 + 2 \times Fsin/Fsout,$ le suivant encore à $t3 = t2 + 2 \times Fsin/Fsout$ et ainsi de suite.

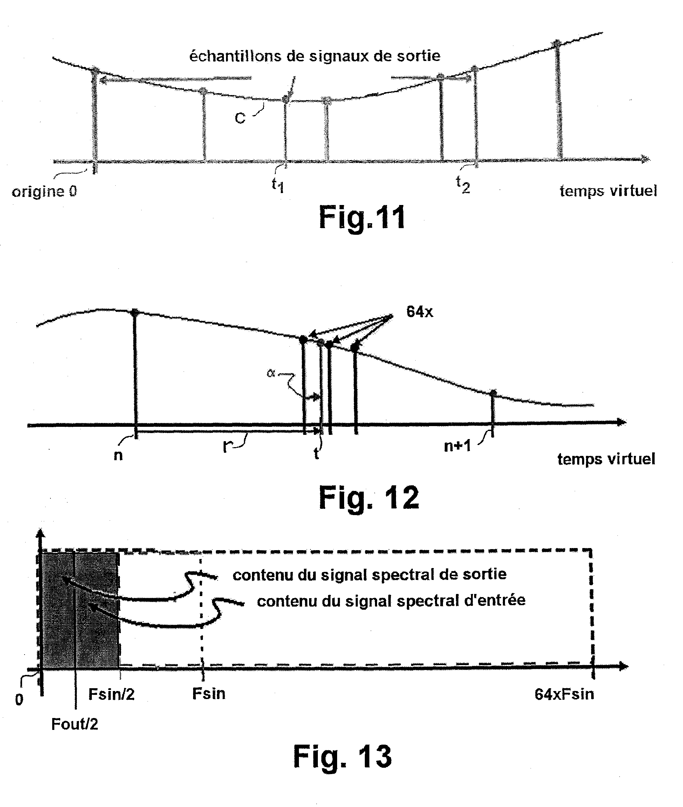

Le diagramme de la figure 12, dérivé de la figure 11, illustre ce processus. De façon plus spécifique, on y a représenté, à titre d'exemple, les instants $t1$ et $t2$.

Une fois que l'instant de temps virtuel d'un échantillon de sortie est connu, on peut déterminer quelles sorties de l'étage de sur-échantillonnage 64x il est nécessaire de connaître. En effet, connaître l'instant de sortie permet déterminer quelle phase de l'étage de sur-échantillonnage64x vient juste à temps avant ce moment comme phases qui seront espacées du soixante-quatrième de l'unité virtuelle de temps. En ayant fixé cette phase, il est nécessaire de calculer cette phase donnée et les deux suivantes pour obtenir trois points de données à partir desquels l'interpolation de données utilisant les "B-Splines" quadratiques est effectuée.

La figure suivante 12 illustre le choix de phases à l'étage de sur-échantillonnage 64x.

Selon les conventions virtuelles de synchronisation rappelées ci-dessus, on définit r tel que t = $n + r$. $r$ est ainsi un nombre tel que $0 \leq r < 1$, $r$ représentant le décalage de temps virtuel entre l'échantillon de sortie par rapport à l'échantillon de signal d'entrée sur-échantillonné 2x qui vient juste avant l'échantillon de sortie. Obtenir l'échantillon de signal d'entrée sur-échantillonné 2x correct est assez simple : connaissant l'instant virtuel $t$ de l'échantillon de sortie, il suffit de sauter au travers des échantillons d'entrée sur-échantillonnés 2x jusqu'à ce que $r = t - n < 1$. Ce processus est habituellement implémenté en décrémentant $t$ d'une unité à chaque nouvel échantillon de signal d'entrée sur-échantillonné 2x.

L'étape de sur-échantillonnage 64x produit des échantillons espacés du soixante-quatrième de la période de temps virtuelle unité et ainsi la phase juste avant le temps virtuel de sortie $t$ est donné par la $k$ ème phase du filtre tel que :

$$k \text{ x } (1/64) \leq r < (k + 1) \text{ x } (1/64) \qquad (9)$$

k est facilement calculé en prenant la valeur entière (arrondie à la valeur inférieure) de *r*x64, par exemple :

$$k = [r \text{ x } 64] \qquad (9bis)$$

relation dans laquelle [ ] représente la partie entière arrondie inférieure.

Les points de données utilisés pour appliquer le "B-Spline" quadratique sont donc donnés par les phases *k, k+1* et *k+2* du sur-échantillonnage 64x filtrent. On doit noter cependant que puisque k est compris entre 0 et 63, *k+1* et *k+2* peuvent réellement excéder 63 et ainsi, dans ce cas, l'entrée sur-échantillonnée 2x nécessite d'être réalisée par pas, et *k+1* et *k+2* diminués de 64 si nécessaire.

A ce point, on dispose des trois points de données pour calculer le "B-Spline". La valeur encore manquante est un paramètre que l'on appellera α, paramètre utilisé dans le calcul de coefficient "B-Spline". Ce paramètre α est représenté sur la figure 12.

Afin d'appliquer l'interpolation quadratique "B-Spline", α doit être normalisé dans l'intervalle [0 ; 1 [. Avec la base de temps virtuel, α varierait dans l'intervalle dans [0 ; 1/64 [. Aussi, afin d'obtenir un paramètre α normalisé, on utilise la relation suivante :

$$\alpha = r \text{ x } 64 - k = r \text{ x } 64 - [r \text{ x } 64] \qquad (10)$$

relation dans laquelle [ ] est défini comme ci-dessus (relation (9bis)).

Une fois le paramètre α normalisé dans [0 ; 1[, les formules quadratiques d'interpolation de "B-Spline" (comme défini ci-dessus) peuvent être appliquées pour calculer l'échantillon de sortie.

Il est très important de noter qu'il n'existe a priori aucune limitation en ce qui concerne la fréquence maximale possible *Fsout.* La dernière étape étant en temps continu (on obtient un polynôme de "B-Splines" qui peut exprimer la valeur du signal à tout moment en temps virtuel), la seule limitation de fréquence maximale *Fsout* est liée à la seule puissance de calcul du dispositif de mise en oeuvre du procédé, c'est-à-dire ne dépend que des possibilités offertes par les technologies actuellement disponibles.

On va maintenant décrire le cas du sous-échantillonnage.

Dans ce cas, la fréquence d'échantillonnage de sortie *Fsout* est inférieure à la fréquence d'échantillonnage d'entrée *Fsin.* Ceci signifie qu'il existe un contenu du domaine de fréquence du signal d'entrée que le signal de sortie ne peut pas reproduire, et cela en raison du théorème d'échantillonnage. Ainsi, il est nécessaire d'introduire un filtre qui limite la largeur de bande du signal d'entrée à *Fsout*l2.

On va tout d'abord considérer le cas particulier pour lequel *Fsin*/2 ≤ *Fsout* < *Fsin* et ensuite, généraliser à *Fsout* < *Fsin.*

On suppose également que le filtre passe-bas possède les caractéristiques indiquées dans la TABLE III placée en fin de la présente description.

Si ce filtre est maintenant utilisé comme un sur-échantillonneur 2x, on obtient un signal échantillonné à 2x*Fsin*, dont tout le contenu en fréquence est enlevé, pour le moins très fortement atténué, au-dessus de Fsout/2, et ainsi au-dessus de *Fsin*/2. On peut alors appliquer l'étape de sur-échantillonnage 64x et l'étape d'interpolation de "B-Splines", comme dans le cas de sur-échantillonnage, et obtenir le résultat désiré de fréquence d'échantillonnage de *Fsout.* Étant donné que *Fsout<Fsin* et que le filtre introduit a ramené la largeur de bande de signal d'entrée à *[0 ; Fsout*l2 [, on peut appliquer le même algorithme que pour l'étape de sur-échantillonnage.

En effet, ce qui a été réalisé est la modification de la première étape pour passer d'un filtrage pur en sur-échantillonnage (cas de sur-échantillonnage décrit en regard de la figure 8) à un sur-échantillonnage avec limitation de bande de fréquence. Ce filtre, au lieu de transmettre tout le contenu en fréquence du signal d'entrée, limite la largeur de bande du signal d'entrée à *Fsout*l2.

Un schéma en bloc-diagramme correspondant à ce cas est d'ailleurs tout à fait similaire à celui de la figure 8, à la seule exception du premier étage (bloc 20) qui, outre le sur-échantillonneur x2, comprend le filtre de limitation de bande précité. Il et donc inutile de le représenter de nouveau.

Dans un mode de réalisation préféré, pour le premier cas de sous-échantillonnage, les étapes du procédé sont les suivantes :

- Etape 1, dénommée "limitation de bande 2x sur-échantillonnage" (bloc 20 de la figure 8 modifié) : tout d'abord, le signal d'entrée est sur-échantillonné par un facteur 2 et limité en bande passante à *Fsout*/2. Ceci crée un signal interne échantillonné à 2x*Fsin* avec un spectre vide à partir de *Fsout*/2 vers les fréquences hautes (le signal d'entrée à bande limitée occupe seulement la largeur de bande 0 à *Fsout*/2, au lieu de 0 à Fsin/2).
- Etape 2, dénommée "sur-échantillonnage 64x" (identique au bloc 21 de la figure 8) : le signal est sur-échantillonné par un facteur de 64, ayant pour résultat un signal interne échantillonné à 128x*Fsin* et possédant un spectre vide de *Fsout*/2 jusqu'à 64x*Fsin* = 128x*Fsin*/2.
- Etape 3, dénommée "interpolation "B-Spline" quadratique" (identique au bloc 22 de la figure 8) : une interpolation "B-Spline" quadratique est effectuée lors de cette étape finale pour générer un signal de sortie sur-échantillonné de fréquence *Fsout*. Comme le contenu spectral a été réduit à *Fsout/2 par* le filtre de limitation de bande, il n'y a aucun risque d'apparition de composants de fréquence de repli de bande ("aliasing") dans la gamme de fréquence de sortie (soit 0 à *Fsout*/2). L'interpolation est effectuée sous la commande d'un signal représentant le rapport de fréquence d'échantillonnage *Fsratio = Fsin/Fsout*. Comme précédemment, ce paramètre de commande est transmis à une entrée d'un bloc (identique au bloc 22) qui délivre en sortie le signal de sortie à la fréquence d'échantillonnage *Fsout.*

Le diagramme de la figure 13 illustre ce processus. L'axe vertical représente l'amplitude A du signal et l'axe horizontal est gradué en fréquence. On y a représenté les fréquences *Fout/2, Fsin/2, Fsin* et 64x *Fsin.* Dans les parties inférieures du spectre, entre 0 et *Fsout*/2, d'une part, et *Fsout*/2 et *Fsin*/2, d'autre part, on a représenté en grisé les contenus de spectre de fréquences non vides pour les signaux de sortie et d'entrée, respectivement. Au-dessus de *Fsin*/2, le spectre est vide.

Il est clair de la description qui précède qu'un dispositif convertisseur de fréquence d'échantillonnage conforme au procédé de l'invention, dans le premier cas de sous-échantillonnage, possède une architecture strictement identique à celle du cas de sur-échantillonnage, à l'exception toutefois de l'introduction d'un filtre de limitation de bande approprié, ce qui constitue une caractéristique très importante de l'invention et présente un avantage certain

La génération d'un filtre limiteur de bande conforme à l'invention va maintenant être décrite de façon plus détaillée.

Selon une caractéristique importante, on sépare la limitation de bande passante, ce qui permet de bloquer les fréquences qui pourraient constituer des fréquences fantômes dans la bande de fréquence de sortie, de l'interpolation, qui permet le transfert effectif d'une base de temps à l'autre. Ceci présente plusieurs avantages principaux :

- La partie adaptative de temps (interpolation) est très simple à réaliser dans cette approche. Dans un mode de réalisation préféré, seuls trois coefficients de filtre sont adaptatifs (par exemple les coefficients de "B-Spline" quadratique) et ont besoin d'être calculés en temps réel. Ceci a pour résultat un faible volume de calcul.
- La séparation des étapes de limitation de bande passante et d'interpolation permet de calculer les coefficients de limitation de bande du filtre en temps différé (et donc, par exemple, pas dans le chemin de traitement en temps réel) et, de ce fait, permet un faible volume de calculs instantanés.
- Comme il sera détaillé ci-après, le procédé selon l'invention n'exige pas un algorithme spécial de calcul des coefficients de limitation de bande du filtre. En fait, l'algorithme utilisé pour le cas de sur-échantillonnage est également utilisé pour calculer les coefficients de filtre, éliminant ainsi le recours à un algorithme spécial de calcul de coefficient de filtre. Ceci constitue une des caractéristiques primordiales du procédé selon l'invention et un de ses avantages principaux.

Le procédé de génération de coefficients de filtre de limitation de bande est basé sur une propriété bien connue en soi de la transformée de Fourier.

On suppose que x représente un signal dans le "domaine temps", *X* est sa représentation dans le "domaine fréquence" et que *FT* représente de plus l'opérateur de transformée de Fourier. on suppose que *k* est un nombre réel non négatif différent de zéro quelconque et que *t* et *f* représentent respectivement le temps et la fréquence. En raison des propriétés de la transformée de Fourier, on peut écrire :

$$FT(x(kt))(f) = X(f/k) \qquad (11)$$

On va maintenant considérer le filtre standard de sur-échantillonnage 2x qui a été utilisé pour le cas de sur-échantillonnage Dans un mode de réalisation préféré, le filtre possède des caractéristiques typiques indiquées dans la TABLE IV placée en fin de la présente description.

On considère maintenant la situation pour laquelle $Fsin/2 \leq Fsout < Fsin,$ ce qui implique que la relation suivante soit vérifiée : $\frac{1}{2} \leq Fsout/Fsin < 1$. On suppose que $r = Fsout/Fsin < 1$. On considère alors le signal $h,$ on applique la conversion de fréquence d'échantillonnage avec le rapport $Fsratio = r$. Comme $r < 1$, on se retrouve de nouveau dans le mode sur-échantillonnage, et il devient possible d'appliquer de nouveau les étapes précédemment décrites. On dénommera $h_{out}$ le signal de sortie correspondant. Ainsi, $h_{out}$ représente le signal $h(n)$ ré-échantillonné aux instants $rn,$ par exemple $h_{out}(n)=h(rn)$. Ainsi, dans le domaine de fréquence, on obtient :

$$FT(h_{out}(n))(f) = H_{out}(f) = H(f/r) \qquad (12),$$

ce qui signifie que le filtre $h_{out}(n)$ possède les caractéristiques indiquées dans la TABLE V placée en fin de la présente description.

Cette approche utilise donc bien l'algorithme fondamental "SRC" pour calculer les coefficients du filtre limiteur de bande, n'exigeant de ce fait aucune ressources spéciale ou dédiée à cette tâche, ce qui constitue, comme on l'a indiqué, un avantage important.

On va maintenant décrire le cas le plus général de sous-échantillonnage, c'est-à-dire lorsque l'inégalité $Fsout<Fsin/2$ est vérifiée.

On va montrer que ce cas peut facilement être dérivé du cas précédemment décrit pour lequel $Fsin/2 < Fsout< Fsin,$ ce à condition de d'insérer des étapes supplémentaires de sous-échantillonnage.

Lorsque $Fsout< Fsin/2,$ il existe un nombre entier positif unique différent de zéro $M$ tel que :

$$2^{-M}Fsin/2 \leq Fsout < 2^{-M} Fsin \qquad (13)$$

En effet, ce nombre entier $M$ peut être calculé facilement en utilisant l'algorithme itératif suivant :

- Étape 1 : initialisation de $M = 0$ ;
- Étape 2 : $M = M + 1$ ; et
- Étape 3 : si $2^{-M}Fsin/2 \leq Fsout,$ alors sortir de l'itération, aller à l'étape 2.

On suppose alors que l'on force le signal d'entrée à traverser $M$ étages de circuit de sous-échantillonnage x2. Dans ce cas, le signal résultant a une fréquence d'échantillonnage $Fsin= 2^{-M}Fsin.$ Ainsi la relation suivante est vérifiée :

$$Fsin'/2 \leq Fsout < 2^{-M}Fsin' \qquad (14)$$

Cette relation est tout à fait similaire au cas déjà considéré pour lequel $Fsin/2 \leq Fsout < Fsin,$ $Fsin$ étant simplement remplacé par un signal de fréquence d'échantillonnage $Fsin'$.

Ainsi, pour implémenter le cas $Fsout < Fsin/2$, il suffit d'exécuter les étapes suivantes :

Étape 1 : initialisation pour obtenir $M$ ;
Étape 2 : application d'un sous-échantillonnage par 2 (x2) de M étages pour obtenir $Fsin' = 2^{-M}Fsin$ ;
Étape 3 : application des étapes du cas précédant avec $Fsin'/2 < Fsout < Fsin'$ ; et
Étape 4 : S'il y a encore des données à être converties en fréquence d'échantillonnage, retourner à l'étape à l'étape 2.

Un dispositif de mise en oeuvre du procédé selon l'invention pour le cas $Fsout < Fsin/2$ est donc directement dérivé de celui du cas précédent (c'est-à-dire pour lequel $Fsin/2 \leq Fsout < Fsin$). Il suffit de faire précéder le premier bloc d'une cascade de $M$ étages de sous-échantillonnage par deux (x2). Il a été également indiqué que ce dernier dispositif était lui-même dérivé directement du dispositif (figure 8) de mise en oeuvre du cas "sur-échantillonnage" pour lequel $Fsout > Fsin.$ Seul le premier étage (bloc 20) devait être légèrement modifié en y incluant un filtre de limitation de bande à $Fsout/2$.

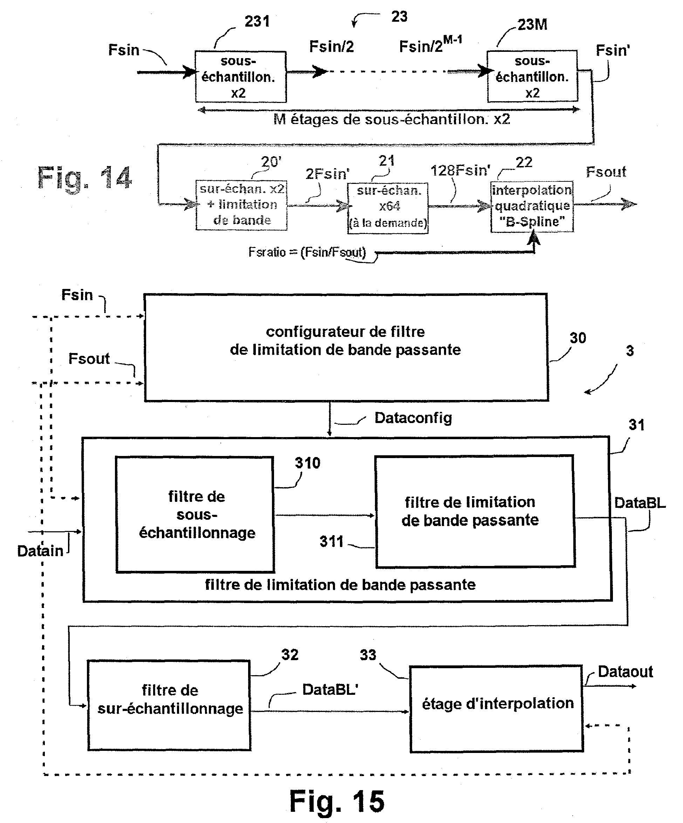

La figure 14 illustre schématiquement, sous forme d'un bloc diagramme, l'architecture d'un dispositif implémentant le procédé.

Les blocs 21 et 22 sont strictement identiques, dans leurs fonctions aux blocs de mêmes références de la figure 8. Le bloc 20' est similaire au bloc 20 mais incorpore un filtre de limitation de bande à *Fsout*/2, comme il a été rappelé. Enfin, le bloc d'entrée, référencé 23, comprend une cascade de *M* étages identiques, 231 à 23*M*, de sous-échantillonnage par deux (x2). Il reçoit le signal d'entrée *Fsin* et délivre un signal de sortie *Fsin'* transmis à l'entrée du bloc 20'. Chaque étage du bloc 23, 231 à 23M, délivre un signal sous-échantillonné par deux par rapport au signal reçu sur son entrée : $Fsin/2, ..., Fsin/2^{M-1}, Fsin' = Fsin/2^{M}$. Il s'ensuit que le bloc 20' délivre sur sa sortie un signal 2Fsin' et le bloc 21 un signal 128*Fsin'*. Le bloc 22, d'interpolation quadratique "B-Spline" délivre le signal de sortie *Fsout,* sous la commande du paramètre de rapport *Fsratio* = (*Fsin*/*Fsout*).

Cette architecture couvre tous les cas possibles de conversion de fréquence d'échantillonnage.

Le nombre d'étapes sous-échantillonnage est dynamiquement déterminé une fois que *Fsin* et *Fsout* sont connus. En effet, il est suffisant de connaître le rapport *Fsratio = (Fsin*/*Fsout),* ou encore le rapport *Fsout*/*Fsin,* ce qui revient au même.

En raison de la séparation architecturale des processus de sous-échantillonnage, de limitation de bande et d'interpolation, selon l'une des caractéristiques importante du procédé de l'invention, comme il a été indiqué, il n'y a pas de limitation théorique en ce qui concerne l'amplitude possible de conversion de fréquence d'échantillonnage, même quand *Fsout < Fsin.* Il est juste suffisant de prévoir un nombre approprié *M* d'étapes de sous-échantillonnage, et donc également d'étages de sous-échantillonnage pour un dispositif implémentant le procédé.

Dans une exécution du procédé réalisée à l'aide d'un élément de logiciel, ceci peut être obtenu en allouant dynamiquement des emplacements d'une mémoire centrale d'un système de traitement automatique de données à programme enregistré, par exemple une mémoire de type dit "RAM", aux étapes de sous-échantillonnage. Les seules limitations rencontrées en pratique sont dues à la puissance de l'unité centrale de traitement disponible et/ou à la quantité disponible de mémoire informatique de dispositif. Il n'y a donc aucune limitation théorique en ce qui concerne le rapport de conversion possible *Fsin*/*Fsout.* Cette caractéristique extrêmement importante présente un avantage technique décisif sur les procédés de l'Art Connu.

De ce qui précède, on constate que le procédé de conversion de fréquence d'échantillonnage conforme à l'invention se décline selon quatre caractéristiques, comme rappelé ci-dessous :

1. Un filtre de limitation de bande passante à *Fsout*/2 disposé en 'entrée et agissant seulement lorsque *Fsin > Fsout.*
2. Un filtre de sur-échantillonnage élevant la fréquence d'échantillonnage du signal d'entrée par un facteur *L,* pour atteindre une fréquence d'échantillonnage égale à *LxFsin ou LxFsin'* (selon le rapport existant entre *Fsin* et *Fsout*), de telle sorte que l'opération d'interpolation qui suit n'engendre pas de distorsion significative.
3. Un étage d'interpolation recevant en entrée le signal de sortie du filtre de sur-échantillonnage précité et générant directement le signal de sortie échantillonné à la fréquence *Fsout.*
4. Un étage de configuration du filtre de limitation de bande passante disposé en entrée tel que :

    4.1. si $Fsin > Fsout \geq Fsin/2$ :

        (a) on utilise un prototype donné de filtre "FIR" caractérisé par sa réponse impulsionnelle ;
        (b) on utilise l'algorithme de conversion de fréquence d'échantillonnage proprement dit pour ré-échantillonner cette réponse impulsionnelle selon un rapport de fréquences d'échantillonnage de *Fsratio = Fsin*/*Fsout,* supérieur à l'unité, pour obtenir les coefficients d'un nouveau filtre "FIR" dont les caractéristiques fréquentielles sont identiques à celles du prototype, selon un rapport homothétique à *Fsout*/*Fsin* ;
        (c) on utilise ce nouveau filtre "FIR" comme filtre de limitation de bande passante à Fsout/2.

    4.2. Si Fsin/2 > Fsout :

        (a) on détermine l'unique entier k tel que $Fsin/2^k > Fsout \geq Fsin/(2^{(k+1)})$;
        (b) on configure et active un filtre de sous-échantillonnage par un facteur $2^k$ en entrée du dispositif "SRC" ;
        (c) on configure un filtre de limitation de bande passante de façon identique au point 4.1 ci-dessus, mais cette limitation étant appliquée à un signal d'entrée échantillonné à la fréquence $Fsin' = Fsin/2^k$ (c'est-à-dire à la sortie du filtre de sous-échantillonnage) ;
        (d) le filtre de limitation de bande passante est, dans ce cas, la combinaison du filtre de sous-échantillonnage et du filtre de limitation de bande passante. On dénote par *Fsin'* la fréquence de sortie de ce filtre, c'est-à-dire $Fsin/2^k.$

    4.3. Si $Fsin \leq Fsout,$ le filtre de limitation de bande passante se limite au prototype de filtre "FIR" utilisé au point 4.2.

En particulier, on peut noter que la partie adaptive du filtre de limitation de bande passante ne doit admettre qu'une plage de variation réduite. En effet, selon une caractéristique importante de l'invention, il est toujours possible de se ramener au cas pour lequel *Fsin > Fsout > Fsinl 2*. Ainsi, le filtre ne doit être adaptable en fréquence de coupure que sur la plage [*Fsin*/4; *Fsin*/2]. Le facteur de division par deux est la conséquence du théorème de Shannon. On dénote par *Fsin'* la valeur *Fsinl2$^k$* si *Fsinl2 > Fsout*, et *Fsin' = Fsin* dans tous les autres cas.

Les caractéristiques essentielles du procédé selon l'invention qui viennent d'être rappelées peuvent être représentées schématiquement par le bloc diagramme de la figure 15, sous la référence générale 3.

Le bloc 30 illustre l'étape de configuration de filtre de bande passante. Il reçoit en entrée les valeurs des fréquences d'échantillonnage d'entrée et de sortie, *Fsin* et *Fsout,* respectivement. Il est défini si *Fsin ≤ Fsout* (voir point 4.3.), *Fsin > Fsout ≥ Fsinl2* (voir point 4.1.) ou si *Fsinl2 < Fsout* (voir point 4.3.). En fonction de quoi, le filtre de sous-échantillonnage est configuré et les coefficients du filtre de limitation de bande passante calculés. En sortie, on obtient un paramètre, référencé *Dataconfig* sur la figure 15, permettant la configuration du filtre de sous-échantillonnage et des coefficients du filtre de limitation de bande passante.

Ce paramètre *Dataconfig* est transmis à un bloc 31, constitué par le filtre de limitation de bande passante. Le bloc 31 reçoit en outre sur deux entrées supplémentaires la valeur de la fréquence d'échantillonnage Fsin et des données d'entrée *Datain* échantillonnées à cette fréquence. Le bloc 31 comprend un filtre de sous-échantillonnage 310 et le filtre de limitation de bande passante proprement dit 311 (étape optionnelle selon le cas considéré).

Le filtre de limitation de bande passante 310 est dynamiquement configuré. Il est mis en fonction si et seulement si *Fsinl2 > Fsout* (voir point 4.2.).

Le filtre de limitation de bande passante 311 est configuré dans la plage *Fsin > Fsout > Fsin*/2. (voir point 4.1.).

Le signal de sortie *DataBL,* généré par le bloc 31, plus précisément par le bloc 311, est constitué par les données d'entrée limitée en bande passante à la fréquence d'échantillonnage *Fsin'* (telle que définie précédemment).

Le signal *dataBL* est transmis à un filtre 32 de sur-échantillonnage par un facteur L.

Le signal *DataBL'* généré en sortie par ce filtre 32 est un signal limité en bande passante de fréquence d'échantillonnage *LxFsin'*. Ce signal *DataBL'* est transmis à l'entrée de l'étage d'interpolation 33.

L'étage d'interpolation 33 est agencé de telle manière qu'il n'introduise pas de distorsion et produise un signal échantillonné à la fréquence *Fsout.*

Le procédé selon l'invention qui vient d'être décrit peut être implémenté à l'aide d'une pièce de logiciel en coopération avec des circuits de calcul et de stockage de données, mémoires fixe (par exemple du type "ROM" précité) et/ou volatile à accès aléatoire (par exemple de type "RAM" précité), notamment pour le stockage des coefficients de filtre. Le procédé peut également être implémenté en faisant appel à des circuits logiques spécifiques, associés à des circuits de mémoires, à système de traitement automatique de données à programme enregistré : micro-ordinateur standard ou à processeur spécialisé dans le traitement de signaux numériques, par exemple du type connu sous la dénomination anglo-saxonne "DSP" (pour "Digital Signal Processor"), associé à des moyens de mémorisation.

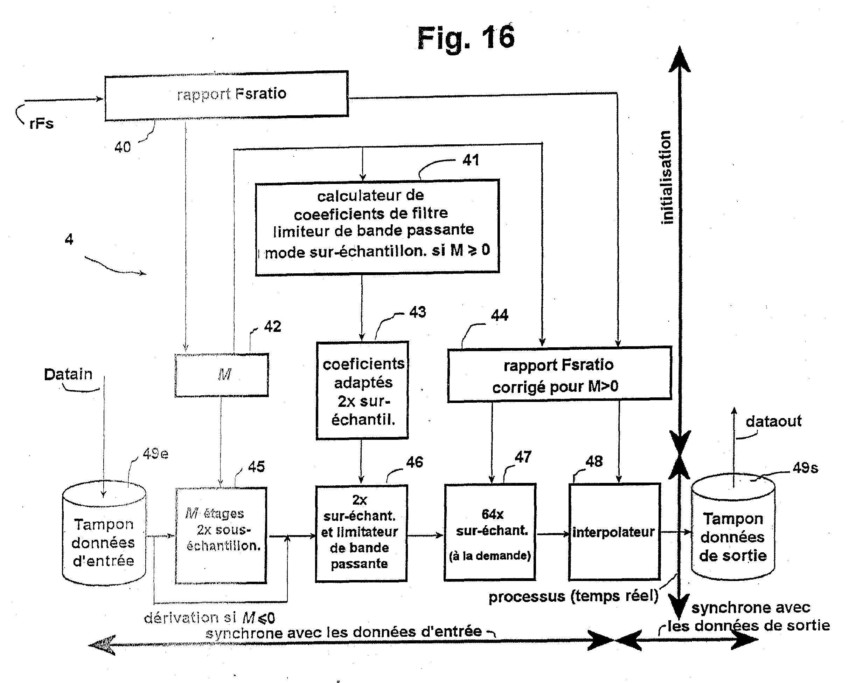

La figure 16 illustre schématiquement un exemple d'architecture d'un dispositif implémentant le procédé de conversion de fréquence d'échantillonnage conforme à un mode de réalisation préféré de l'invention, sous la référence générale 4.

Les modules de circuits représentés dans la partie supérieure de la figure 16, concernent des étapes d'initialisation du procédé.

Un premier module 40 reçoit un paramètre *rFs* permettant de calculer le rapport désiré *Fsratio* entre les fréquences d'échantillonnage des signaux d'entrée et de sortie.

Ce rapport *Fsratio* est transmis à un module 42 générant en résultat le facteur *M* précédemment défini et à un module 44 de correction du rapport *Fsratio,* si l'inégalité *M>o* est vérifiée.

Le facteur *M* est transmis à l'entrée de deux modules : un module 41 de calcul des coefficients de filtre limiteur de bande passante et au module 44 de correction de correction du rapport *Fsratio* précité. La limitation de bande passante n'est effective que si *M≥0*.

Le signal en sortie du module 41 est transmis à un module 43 d'adaptation des coefficients du sur-échantillonnage 2x, calculs effectués dans tous les cas.

Les modules de circuits représentés sur la partie basse de la figure 16 correspondent aux étapes réalisées en temps réel du procédé selon l'invention. En outre, sur la partie gauche, jusqu'au module interpolateur 48, le processus est synchrone avec les données d'entrée, référencées *Datain.* A partir de ce module 48, le processus est synchrone avec les données de sortie, référencées *Dataout.*

Les données d'entrée, *Datain,* à la fréquence d'échantillonnage *Fsin,* sont transmis à l'entrée d'une première mémoire tampon 49e, et stockées dans cette mémoire. Il peut s'agir, par exemple, d'une mémoire de type dit "FIFO" (pour "First In First out" ou "Premier entré Premier sorti"). La sortie de ce tampon 49e est transmise, en synchronisme avec le flux de données d'entrée *Datain* à l'entrée d'un module comprenant *M* étages de sous-échantillonnage, *M* étant le paramètre calculé par le module 42. Comme il a été indiqué, cette opération n'est réalisée que si *M≤0*. Dans le cas contraire, on prévoit une dérivation ou "By-pass" selon la terminologie anglo-saxonne couramment utilisée. Les données sont alors transmises directement à un module disposé en cascade avec le module 45. Pour ce faire, le module 45 comprend des moyens de commandes (non représentés) réagissant à la valeur de M pour aiguiller les données entrantes vers les étages de sous-échantillonnage ou vers le "by-pass".

Le module 45 effectue les opérations de sur-échantillonnage 2x et de limitation de bande passante. De nouveau, comme il a été indiqué, cette dernière opération n'est effectuée que dans les modes "sous-échantillonnage".

Le signal en sortie est transmis à un module 47 de sur-échantillonnage 64x qui reçoit sur une entrée de commande le rapport *Fsratio* corrigé si M>0 du module 44. La sortie du module 47 est transmise au module d'interpolation de données 48. Comme il a été indiqué, dans un mode de réalisation préféré, cette interpolation est basée sur des "B-Splines" quadratiques.

Finalement, les données en sortie du module 48 sont stockées dans une mémoire tampon de sortie 49s, qui peut être du même type que la mémoire tampon d'entrée 49e. Celle-ci délivre les données de sortie *Dataout* à la fréquence d'échantillonnage *Fsout,* en fonction du rapport *Fsratio* désiré.

Les applications préférées du procédé de l'invention concernent tout d'abord la conversion de fréquence d'échantillonnage proprement dite, ou "SRC", et plus spécifiquement encore les "SRC" utilisés dans le domaine de l'audio.

Une application classique d'un "SRC" dans ce domaine est de convertir des données audionumériques de fréquence d'échantillonnage donnée en données audio de même nature, mais échantillonnées à une autre fréquence d'échantillonnage. Dans le domaine audionumérique on utilise un grand nombre de fréquences d'échantillonnage, notamment les suivantes : 8, 11,025, 12, 16, 22,05, 24, 32, 44.1, 48, (64), 88,2, 96, (128), 176,4, 192, (352,8 et 384) kHz, les fréquences indiquées entre parenthèses étant peu utilisées, alors que les autres sont d'un usage fréquent, voir quasi-normalisé.

Afin de transférer des données d'un système audionumérique à un autre, il est souvent obligatoire d'adapter la fréquence d'échantillonnage des données car l'un ou l'autre des systèmes audionumériques est incompatible avec les fréquences d'échantillonnage d'autres systèmes auxquels il est relié. Par conséquent, établir une connexion entre deux systèmes incompatibles exige souvent de recourir à un "SRC" en interface.

Une application typique des "SRC" peut être trouvée dans l'industrie automobile pour des systèmes embarqués multimédia. Les architectures modernes de voiture incorporent souvent un bus multimédia de transfert (par exemple un bus du type dit "MOST") fonctionnant à un taux fixe d'échantillonnage, par exemple à 48kHz pour transmettre des données audionumériques aux haut-parleurs arrières de l'automobile. Cependant, il existe d'autres sources audio dans la voiture, services qui utilisent des signaux dont la fréquence d'échantillonnage est différentes de 48 kHz, tel qu'un lecteur de CD avec une fréquence d'échantillonnage de 44,1kHz ou un dispositif dit "mains libres" pour une connexion d'un téléphone portable, au standard "GSM", fonctionnant à 8 kHz. Ainsi, pour transmettre les données audionumériques sur le bus multimédia incorporé, il est nécessaire d'effectuer une conversion de fréquence d'échantillonnage. De façon plus générale, il peut exister n sources de signaux échantillonnés à des fréquences $F_1$, ... , $F_x$, ..., $F_n$ kHz, avec $F_x$ correspondant à l'une ou l'autre des valeurs rappelées ci-dessus. Il sera donc nécessaire de disposer de $x$ "SRC", de rapport de conversion Rx = ($F_x$/48), $F_x$ étant exprimé en kHz. Comme on l'a montré, $R_x$ peut prendre des valeurs quelconques, qu'il s'agisse de modes sur-échantillonnage ou sous-échantillonnage. Les seules limitations sont celles dues aux technologies mises effectivement en oeuvre.

Le procédé selon l'invention n'est cependant pas limité à la conversion de fréquence d'échantillonnage proprement dite. Il peut être mis à profit dans de nombreux domaines.

A titre d'exemple non exhaustif, on peut le mettre en oeuvre pour éliminer la gigue ou "jitter", notamment dans une un convertisseur numérique-analogique.

On sait que le "jitter" est l'un des principaux facteurs de dégradation de la qualité dans les systèmes audionumériques de restitution ou d'enregistrement de sons. Le "jitter" est caractérisé par une variation indésirable de la période d'horloge autour d'une valeur centrale de cette période. On peut le considérer comme étant un signal de bruit présent sur l'horloge audio.

Ces systèmes comprennent un convertisseur numérique-analogique Il est capital, pour obtenir une conversion numérique-analogique de bonne qualité d'éliminer, autant que faire se peut, cet effet de "jitter" parasite.

L'architecture générale d'un tel système comprend habituellement un étage d'entrée récepteur audionumérique qui extrait les signaux numériques et les signaux d'horloge du flux de données entrantes et les sépare en deux chemins distincts. Cet étage est basé sur un oscillateur de type "PLL" (pour "Phase Locked-Loop" ou "Boucle de Phase Asservie"). L'expérience montre que la transmission est de mauvaise qualité, même si le "PLL" effectue un asservissement sur le flux de données entrant. Il existe généralement un "jitter" résiduel indésirable qui obère la qualité du signal audionumérique.

L'étage de sortie effectue la conversion numérique-analogique proprement dite.

Pour éviter ce problème, au lieu de compter sur un signal à faible "jitter", on peut utiliser une horloge locale très précise, étant entendu, qu'il est beaucoup plus aisé d'obtenir un faible "jitter" sur une horloge locale. On intercale un "SRC" entre les deux étages. Ce dernier effectue une conversion de fréquence d'échantillonnage entre la fréquence des signaux d'entrée et celle imposée par l'horloge locale précise. Comme dans le cas de la figure 16, les circuits d'entrées jusqu'au "SRC" sont synchrones avec la fréquence d'échantillonnage des données d'entrées. A partir du "SRC", les circuits de sortie sont synchrones avec la fréquence d'échantillonnage des données de sortie (déterminée par l'horloge interne).

Accessoirement, un avantage supplémentaire obtenu par l'utilisation d'un "SRC" réside dans le fait que l'étage de sortie analogique du convertisseur numérique-analogique ne nécessite d'être optimisée que pour une seule fréquence d'échantillonnage, ce qu'il est aisé d'obtenir. Tout au contraire, dans un dispositif sans "SRC", l'étage de sortie analogique est basé sur des compromis, car il devra être accordé pour des fréquences d'échantillonnage multiples.

A la lecture de ce qui précède, on constate aisément que l'invention atteint bien les buts qu'elle s'est fixée.

En effet, le procédé selon l'invention présente de nombreux avantages, qui ont été précédemment rappelés. Il est inutile de tous les énumérer de nouveau mais on peut citer les principaux, à savoir :

- il présente une faible complexité et des performances élevées ;
- il permet des rapports de conversion entre les fréquences d'échantillonnage d'entrée et de sortie potentiellement illimités ;
- il met en oeuvre le même algorithme pour exécuter la conversion de fréquence d'échantillonnage et dériver les coefficients de filtre limiteur de bande passante ; et
- il n'exige qu'une faible capacité de stockage, puisque le nombre de coefficients de filtre est peu élevé.

Il doit être clair cependant que l'invention n'est pas limitée aux seuls exemples de réalisations explicitement décrits, notamment en relation avec les figures 8 à 16.

Les valeurs numériques et les exemples de circuits utilisables pour remplir les fonctions nécessitées par le procédé (filtrage, sur- et sous-échantillonnage, interpolation, etc.) n'ont été donnés que pour mieux illustrer les caractéristiques principales de l'invention et ne procède que d'un choix technologique à la portée de l'Homme de Métier. Il a été indiqué que la plupart de ces fonctions étaient connues en soi, les caractéristiques innovatrices de l'invention et les avantages techniques obtenues résidant dans leur agencement spécifique. Cet état de fait représente d'ailleurs un avantage supplémentaire, car il est possible de recourir aux technologies de l'Art Connu sans modification importante.

L'invention n'est pas limitée non plus aux seules applications explicitement décrites. Outre l'application principale relative à la conversion de fréquence d'échantillonnage proprement dite, comme il a été rappelé, elle peut être mise à profit dans de nombreux autres domaines.

**TABLE I**

| type de filtre | sur-échantillonnage 2x |
|---|---|
| Fréquence d'échantillonnage | 2 |
| Fréquence supérieure de bande passante | 0,454 |
| Fréquence inférieure de coupure de bande | 0,546 |
| Ondulation de bande passante (en dB) | 0,001 |
| Atténuation de coupure de bande (en dB) | 150 |
| Nombre de prises intermédiaires | 156 |
| Polyphase *N* | 78 |

**TABLE II**

| type de filtre | sur-échantillonnage 64x |
|---|---|
| Fréquence d'échantillonnage | 128 |
| Fréquence supérieure de bande passante | 0,5 |
| Fréquence inférieure de coupure de bande | 1,45 |
| Ondulation de bande passante (en dB) | 0,001 |
| Atténuation de coupure de bande (en dB) | 150 |
| Nombre de prises intermédiaires | 1024 |
| Polyphase *N* | 16 |

**TABLE III**

| type de filtre | passe-bas pour $Fsin/2$ |
|---|---|
| Fréquence d'échantillonnage | 2 |
| Fréquence supérieure de bande passante | 0,454x$Fsout$/$Fsin$ |
| Fréquence inférieure de coupure de bande | 0,546x$Fsout$/$Fsin$ |

**TABLE IV**

| type de filtre | sur-échantillonnage 2x ($h(n)$) |
|---|---|
| Fréquence d'échantillonnage | 2 |
| Fréquence supérieure de bande passante | 0,454 |
| Fréquence inférieure de coupure de bande | 0,546 |

**TABLE V**

| type de filtre | sur-échantillonnage 2x et limitation de bande ($h(n)$) |
|---|---|
| Fréquence d'échantillonnage | 2 |
| Fréquence supérieure de bande passante | 0,454x$r$ = 0,454x$Fsout$/$Fsin$ |
| Fréquence inférieure de coupure de bande | 0.546x$r$ = 0.546x$Fsout$/$Fsin$ |

**Revendications**

**1.** Procédé de conversion de fréquence d'échantillonnage selon un rapport prédéterminé comprenant une première étape d'initialisation consistant à acquérir une première fréquence d'échantillonnage, dénommée $Fsin$, associée à un premier signal numérique, dit d'entrée, et à sélectionner une deuxième fréquence d'échantillonnage, dénommée $Fsout$, associée à un deuxième signal numérique, dit de sortie, le rapport entre lesdites première et deuxième fréquences d'échantillonnage constituant ledit rapport prédéterminé, **caractérisé en ce qu'**il comprend une phase d'initialisation comprenant :

- une première étape d'initialisation consistant à déterminer un nombre entier unique k, tel que la relation :

$$(Fsin/Fsout)/2^k > 1 \geq (Fsin/Fsout)/(2^{(k+1)})$$

soit satisfaite et à enregistrer ledit nombre dans des moyens de mémorisation ;
- une deuxième étape d'initialisation consistant, si k > 0, à configurer un filtre numérique de sous-échantillonnage dudit signal d'entrée par un facteur $2^k$, et à enregistrer les paramètres associés à cette configuration dans des moyens de mémorisation ;
- une troisième étape d'initialisation consistant à configurer un filtre numérique de limitation de bande passante de fréquence de coupure $Fsout/2$ et à déterminer ses coefficients si et seulement si l'une des relations suivantes est satisfaite : $Fsin \leq Fsout$, $Fsin > Fsout \geq Fsin/2$ ou $Fsin/2 < Fsout$, et à enregistrer lesdits coefficients dans des moyens de mémorisation ;

et une phase de processus réalisée en temps réel comprenant :

- une première étape de processus consistant, si et seulement si $k>0$, à appliquer ledit filtre numérique de sous-échantillonnage par un facteur $2^k$ au dit signal d'entrée, de façon à générer un premier signal intermédiaire ;
- une deuxième étape de processus consistant, si et seulement si $k \geq 0$, à appliquer ledit filtre numérique de limitation de bande passante au dit premier signal intermédiaire, et à court-circuiter ce filtre si $k<0$, de façon à générer un deuxième signal intermédiaire ;
- une troisième étape de processus consistant à sur-échantillonner ledit deuxième signal intermédiaire par un facteur prédéterminé $L$ ; et
- une quatrième étape de processus consistant à appliquer audit troisième signal intermédiaire un étage d'interpolation de données numériques de manière à générer ledit signal de sortie à la fréquence d'échantillonnage $Fsout$.

**2.** Procédé selon la revendication 1, **caractérisé en ce que** ledit filtre numérique de limitation de bande passante est un filtre du type dit à réponse impulsionnelle finie.

**3.** Procédé selon la revendication 2, **caractérisé en ce que** ladite troisième étape d'initialisation consistant à configurer ledit filtre numérique de limitation de bande passante comprend les sous-étapes suivantes :

   - choix d'un prototype de filtre à réponse impulsionnelle finie **caractérisé par** une réponse impulsionnelle prédéterminée ;
   - réalisation desdites étapes du procédé de conversion de fréquence d'échantillonnage pour ré-échantillonner ladite réponse impulsionnelle selon ledit rapport prédéterminé $Fsin/Fsout$, de manière à obtenir les coefficients d'un filtre à réponse impulsionnelle finie modifié dont les caractéristiques fréquentielles sont identiques à celles dudit prototype, dans un rapport homothétique au rapport prédéterminé $FsinIFsout$ ;
   - enregistrement desdits coefficients dans des moyens de mémorisation ; et
   - utilisation dudit filtre à réponse impulsionnelle finie modifié comme filtre de limitation de bande passante à la fréquence $Fsout/2$ .

**4.** Procédé selon la revendication 1, **caractérisé en ce que** ladite quatrième étape de processus met en oeuvre une interpolation de données numériques polynomiale par segments du type dit "B-Spline" d'ordre prédéterminé.

**5.** Procédé selon la revendication 4, **caractérisé en ce que** lesdits "B-Splines" sont quadratiques.

**6.** Procédé selon la revendication 1, **caractérisé en ce que** ladite troisième étape de processus comprend :

   - une première sous-étape consistant à sur-échantillonner ledit deuxième signal intermédiaire par un facteur deux ; et
   - une deuxième sous-étape consistant à sur-échantillonner le signal ainsi obtenu par un facteur soixante-quatre, de manière à obtenir ledit troisième signal intermédiaire échantillonné à cent vingt huit fois la fréquence d'échantillonnage dudit deuxième signal intermédiaire.

**7.** Procédé selon l'une quelconque des revendications 1 à 6, **caractérisé en ce qu'**il est réalisé sous la forme d'un élément de logiciel coopérant avec des moyens de calcul et de mémoire d'un système de traitement automatique de données à programme enregistré.

**8.** Procédé selon la revendication 7, **caractérisé en ce que** ledit système de traitement automatique de données à programme enregistré est un micro-ordinateur.

**9.** Procédé selon la revendication 7, **caractérisé en ce que** le système de traitement automatique de données à programme enregistré est un processeur spécialisé de traitement de signaux numériques comprenant des moyens de mémorisation.

**10.** Dispositif pour la mise en oeuvre du procédé selon l'une quelconque des revendications précédentes, **caractérisé en ce qu'**il comprend :

   - une première série de modules dits d'initialisation pour réaliser lesdites étapes d'initialisation et comprenant :

      - un premier module d'initialisation (40) recevant en entrée des données pour générer en sortie ledit rapport de conversion déterminé ;
      - un deuxième module d'initialisation (42) recevant ledit rapport de conversion prédéterminé et générant en sortie ledit facteur prédéterminé de sur-échantillonnage ;
      - un troisième module d'initialisation (41) recevant ce facteur de sur-échantillonnage et, en fonction de sa valeur, calculant les coefficients dudit filtre de limitation de bande passante et les générant sur sa sortie ;
- un quatrième module d'initialisation (44) recevant ledit facteur prédéterminé de sur-échantillonnage et, en fonction de sa valeur, corrigeant sélectivement ledit rapport de conversion prédéterminé et le générant sur sa sortie ; et
- un cinquième module d'initialisation (43) recevant les coefficients dudit filtre passe-bande calculés par ledit troisième module et, calculant sélectivement des coefficients adaptés de sur-échantillonnage et les générant sur sa sortie ;

- et une deuxième série de modules dits de processus pour réaliser les étapes en temps réel comprenant :

- un premier module de processus (45), recevant, sur une première entrée, des données numériques dites d'entrée à ladite première fréquence d'échantillonnage *Fsin* et, sur une seconde entrée, la sortie dudit deuxième module d'initialisation (42), comprenant ledit filtre de sous-échantillonnage de facteur $2^k$, une voie de dérivation le court-circuitant, et des moyens de commande pour faire transiter sélectivement lesdites données d'entrées par ledit filtre de sous-échantillonnage de facteur $2^k$ ou ladite dérivation en fonction de l'état de sortie dudit deuxième module d'initialisation (42) ;
- un deuxième module de processus (46) recevant, sur une première entrée, la sortie dudit premier module de processus (45) et, sur une seconde entrée, la sortie dudit cinquième module d'initialisation (43) et réalisant un premier sur-échantillonnage de facteur deux sur les données reçues sur sa première entrée et un filtrage sélectif de bande passante en fonction de l'état de sortie dudit cinquième module d'initialisation (43) ;
- un troisième module de processus (47) recevant, sur une première entrée, la sortie dudit deuxième module de processus (45) et, sur une seconde entrée, la sortie dudit quatrième module d'initialisation (44) et réalisant, sélectivement en fonction de l'état de sortie de ce quatrième module (45), un premier sur-échantillonnage de facteur soixante-quatre sur les données reçues sur sa première entrée ; et
- un quatrième module de processus (48) recevant en entrée la sortie dudit troisième module de processus (47), réalisant sur les données reçues en entrées ladite interpolation de données numériques et délivrant en sortie des données à la dite deuxième fréquence d'échantillonnage *Fsout.*

**11.** Dispositif selon la revendication 10, **caractérisé en ce qu'**il comprend en outre des premiers moyens de mémorisation formant tampon (49*e*), recevant des données dites d'entrée (*Datain*) à ladite première fréquence d'échantillonnage *Fsin* et les transmettant au dit premier module de processus (45), en synchronisme avec lesdites données d'entrée (*Datain*) , et des seconds moyens de mémorisation formant tampon (49s), recevant les données de sortie dudit quatrième module de processus et les transmettant sous la forme de données dites de sortie *(Dataout),* en synchronisme avec les données reçues en entrée, à ladite deuxième fréquence d'échantillonnage *Fsout.*

EP 1 727 283 A1

**Fig. 1**

Vi (Fsin) → [ Convertisseur de fréquence d'échantillonnage ] 1 → Vo (Fsout)

**Fig. 2**

**Fig. 3**

**Fig. 4**

22

Fig. 5

Fig. 6

Fig. 7

**2**

**20** **21** **22**

Fsin → | 2 x sur-échantil-lonnage | → 2 x Fsin → | 64 x sur-échantillon. (à la demande) | → 128 x Fsin → | interpolation quadratique B-Spline | → Fsout

Fsratio = (Fsin/Fsout)

## Fig. 8

contenu spectral du signal

Fsin/2     Fsin              64xFsin

Fout/2

## Fig. 9

échantillons de signaux d'entrée sur-échantillonnés x2

échantillons de signaux d'entrée

origine 0    saut de temps virtuel de 2   saut de temps virtuel de 1    temps virtuel

## Fig. 10

échantillons de signaux de sortie

C

origine 0

$t_1$

$t_2$

temps virtuel

**Fig.11**

64x

α

n

r

t

n+1

temps virtuel

**Fig. 12**

contenu du signal spectral de sortie

contenu du signal spectral d'entrée

0

Fsin/2

Fsin

64xFsin

Fout/2

**Fig. 13**

Fig. 14

Fig. 15

# Fig. 16

rapport Fsratio

rFs

40

4

initialisation

41

calculateur de
coeeficients de filtre
limiteur de bande passante
mode sur-échantillon. si M ≥ 0

43

44

42

Datain

M

coeficients
adaptés
2x suréchantil.

rapport Fsratio
corrigé pour M>0

dataout

49e

45

46

47

48

49s

Tampon
données
d'entrée

M étages
2x sous-
échantillon.

2x
sur-échant.
et limitateur
de bande
passante

64x
sur-échant.

(à la demande)

interpolateur

Tampon
données
de sortie

processus (temps réel)

synchrone avec
les données de sortie

dérivation si M ≤ 0
synchrone avec les données d'entrée

Office européen
des brevets

Numéro de la demande

EP 06 30 0498

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 5 835 032 A (YASUDA ET AL) 10 novembre 1998 (1998-11-10) * colonne 7, ligne 7 - colonne 9, ligne 64; figure 4 * ----- | 1-11 | INV. H03H17/06 |
| A | GOCKLER H G ET AL: "Minimal block processing approach to fractional sample rate conversion" SIGNAL PROCESSING, AMSTERDAM, NL, vol. 81, no. 4, avril 2001 (2001-04), pages 673-691, XP004234871 ISSN: 0165-1684 * le document en entier * ----- | 1-11 | |

**DOMAINES TECHNIQUES RECHERCHES (IPC)**

H03H

Le présent rapport a été établi pour toutes les revendications

| Lieu de la recherche | Date d'achèvement de la recherche | Examinateur |
|---|---|---|
| La Haye | 2 août 2006 | Lecoutre, R |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**EP 1 727 283 A1**

## ANNEXE AU RAPPORT DE RECHERCHE EUROPEENNE
## RELATIF A LA DEMANDE DE BREVET EUROPEEN NO.

EP 06 30 0498

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-08-2006

| Document brevet cité au rapport de recherche | | Date de publication | Membre(s) de la famille de brevet(s) | | Date de publication |
|---|---|---|---|---|---|
| US 5835032 | A | 10-11-1998 | US | 5996044 A | 30-11-1999 |
| | | | US | 5748120 A | 05-05-1998 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6747858 B1, Terry L. Sculley
- US 6141671 B1, Robert W. Adams
- US 6208671 B1, John Paulos